# EUROPEAN PATENT APPLICATION

(11) **EP 1 462 859 A2**
(43) Date of publication of application: **29.09.2004**
(21) Application number: 04007133.4
(22) Date of filing: 24.03.2004
(51) Int. Cl.: G03F 7/095

(54) **Resin molded product production process, metal structure production process, and resin molded product**

(30) Priority: 24.03.2003 JP 2003080140
(71) Applicant: Kuraray Co., Ltd., Okayama 710-8622 (JP)
(72) Inventor: Nishi, Taiji, c/o Kuraray Co., Ltd., Ibaraki 305-0841 (JP); Kitani, Takenori, c/o Kuraray Co., Ltd., Ibaraki 305-0841 (JP); Fukuda, Motohiro, c/o Kuraray Co., Ltd., Ibaraki 305-0841 (JP); Yanagawa, Yukihiro, c/o Kuraray Co., Ltd., Ibaraki 314-0197 (JP); Nagayama, Rei, c/o Kuraray Co., Ltd., Ibaraki 314-0197 (JP)
(74) Representative: VOSSIUS & PARTNER

(57) **Abstract**

A resin molded product production process has a resist pattern formation step including formation of the first resist layer on s substrate, positioning of the substrate and a mask A, exposure of the first resist layer using the mask A, heat-treatment of the first resist layer, formation of the second resist layer on the first resist layer, positioning of the substrate and a mask B, exposure of the second resist layer using the mask B, heat-treatment of the second resist layer, and development of the resist layers, thereby creating a given resist pattern. The production process further has a metal structure formation step of depositing a metal on the substrate in accordance with the resist pattern by plating, and a molded product formation step of forming a resin molded product by using the metal structure as a mold. A resin molded product is thereby produced.

## Description

The present invention relates to a process for producing a resin molded product having a given pattern height or different pattern heights, a resin molded product obtainable thereby, and a process for producing a metal structure for the production of a resin molded product. The process according to the present invention is particularly effective in producing a resin molded product for diagnosis, reaction, separation, measurement, and so on in the clinical laboratory field, the genetic engineering field, and the combinatorial chemistry field, or a resin molded product for a channel member for a fuel cell.

As societies mature, values on medical care and health have changed. People now seek a healthy and high-quality life, notmerelyaprimaryhealthcare. This change invalues leads to increases in medical care costs and in the number of those who are in between healthy and diseased. With this background and the fact that disease prevention is less costly than treatment, it is expected that more and more individuals will place a higher value on preventive medicine than on curative medicine. On this account, in the medical field, and particularly, in the clinical laboratory field, there is an increasing need for a non-restraint examination system that enables prompt examination and diagnosis in the vicinity of a patient such as at an operating room, bedside, andhome, andanoninvasiveorminimallyinvasiveexamination system that requires only a small amount of sample of blood and so on.

In order to achieve the non-restraint examination system allowing prompt examination and diagnosis, it is required, for example, to provide portability to the system by miniaturization of a substrate used in examination and diagnosis.

If the diameter of a channel is reduced from 1 mm to 0.1 mm, for example, with micromachine technology, it not only reduces sample requirements but also shortens mixing time to one-tenth. The reduction of the channel diameter also provides portability to a system and also allows the system to perform the same function as conventional large-size systems. Further, the miniaturization of the channel will allow arrangement of a plurality of channels in one substrate, enabling parallel processing.

For the channel miniaturization, there is a need for amolding technique that cancreatedifferentpatternheights, such as 30 µm and 100 µm, in order to effectively mix sample and reagent, or mount a sensor, an electrode, a connecter, and so on in one substrate.

The miniaturization is needed in the combinatorial chemistry field, and particularly, in High-Throughput Screening (HTS) in pharmaceutical development. The combinatorial chemistry is an approach to chemical synthesis that enables the creation of large numbers of organic compounds (libraries) by linking chemical building blocks in all possible combinations.

The High-Throughput Screening uses 96-well plates and 384-well plates, which allow screening of a plurality of samples at the same time. Those plates, in combination with an automatic dispenser, for example, contribute to the acceleration of new drug development.

If the width or diameter of a reservoir is reduced from 10 mm to 0.4 mm and the height from 10 mm to 0.3 mm, for example, with themicromachine technology, it is possible to provide 1, 000 to 5, 000 micro-reservoirs in one substrate, thereby enabling the significant acceleration of new drug development.

For the reservoir miniaturization, there is a need for a molding technique that can create different pattern heights, such as 0.1 mm and 0.3 mm, in order to perform screening of different experimental compounds with different characteristics and so on or to perform screening in accordance with the amount of sample.

The miniaturized system is needed in the combinatorial chemistry field, and particularly, in chemical synthesis and analysis in the chemical industry.

With the worldwide progress of the human genome project, the number and types of diseases for which DNA diagnosis is possible are ever-increasing. Consequently, various diseases which have been indirectly diagnosed by the biochemical analysis can now be definitively diagnosed at a DNA level to determine the cause and mechanism of the diseases. Further, it is expected that a substrate used for diagnosis for the individually tailored medication with no side effects and the individualizeddiagnosis of specified diseases, called personalized medicine, will become widely used in a local clinic level.

There is a need for an accurate and low-cost substrate to reduce sample requirements, shorten diagnosis time, and provide portability to an examination system.

Widely used methods in the genetic area are capillary electrophoresis, microarray, and Polymerase Chain Reaction (PCR). The PCR method provides an extremely sensitive means of amplifying small quantities of genome samples 100,000 times or more for detection. The capillary electrophoresis method injects a sample into a capillary with the diameter of 100 to 200 µm, separates compounds by electrophoresis, and optically detects them. If the capillary diameter is reduced, more rapid diagnosis will be achieved. The reduction of the capillary diameter will also allow arrangement of a plurality of capillaries in one substrate, enabling parallel processing.

For the miniaturization of the capillary diameter, there is a need for a molding technique that can create different pattern heights, such as 30 µm and 100 µm, in order to perform effective separation and detection, or mount electronic sensors and other components in one substrate, and so on.

The microarray method generally uses a fluorescence intensity method for detection, and it is not possible to obtain accurate gene expression data if detection sensitivity and reproducibility are low. One approach to increase the detection sensitivity and reproducibility without decreasing the array density on a substrate is to enlarge an array area. However, since there is a limit to the enlargable size of a plane substrate, it is not possible to obtain given detection sensitivity and reproducibility without decreasing the array density on the substrate. If it is possible to produce a substrate having a fine raised or recessed pattern, it will enable greatly increasing an array area and capacity, thereby improving the detection sensitivity and reproducibility.

For the miniaturization, there is a need for a molding technique that can provide different pattern heights, such as 30 µm and 100 µm, in order to perform screening of compounds with different characteristics and so on or to perform screening in accordance with the amount of sample.

The PCR method amplifies the target DNA fraction a billion times in a short time by using polymerase. The miniaturization of reservoirs will not only enhances speed and efficiency, but also reduces the amount of expensive antibody and substrate used, thus achieving cost reduction. Further, if it is possible to place a plurality of channels, mixing parts, and reservoirs in one substrate by their miniaturization, it will enable performing the capillary electrophoresis and the PCR on the same substrate.

For the reservoir miniaturization, there is a need for a molding technique that allows creation of different pattern heights, such as 30 µm and 100 µm, in order to perform screening of different experimental compounds with different characteristics and so on or to perform screening in accordance with the amount of sample.

Conventionally, resin molded products have been producedbyinjectionmolding, blowmolding, orpressmolding by using a metal mold formed by molding or machining.

However, when producing a metal mold by molding, a limit to the mold accuracy imposes restrictions to a pattern of the metal mold. Whenproducingthemetalmoldbymachining, on the other hand, there is a limit to a cutting tool and cutting accuracy. Thus, neither processing technique can produce a resin molded product with an accurate and fine pattern.

As described above, when using a metal mold produced by molding or machining, neither processing technique achieves a resin molded product with an accurate and fine pattern.

Consequently, if the conventional resin molded product is used in the clinical laboratory field, particularly for blood testing, urine testing, biochemical analysis and so on, there is a limit to the accuracy and miniaturization of channels and reservoirs, thus requiring a large amount of sample such as blood. Further, when using the resin molded product produced by molding or machining, it is not possible to provide portability to examination and diagnosis systems.

If the resin molded product formed from the metal mold produced by molding or machining is used in combinatorial chemistry applications, particularly for the high throughput screening in the pharmaceutical development, there is a limit to the miniaturization of reservoirs, which makes it impossible to accelerate new drug development and reduce sample requirements for cost reduction.

Similarly, if the above resin molded product is used in combinatorial chemistry applications, particularly for chemical synthesis and analysis in the chemical industry, the limit to the accuracy and miniaturization of channels makes it impossible to reduce the time for chemical synthesis and analysis, reduce the amount of drug used for mixture and reaction, reduce the amount of waste solution, and reduce environmental burdens.

Similarly, if the resin molded product produced using the metal mold by molding or machining is used in genetic applications, particularly for analysis by capillary electrophoresis and microarray, and amplification by PCR, the limit to the miniaturization makes it impossible to increase the analyzing speed and reduce the sample requirements. Further, use of the metal mold produced by molding or machining makes it impossible to reduce the substrate size.

A processing technique to solve the above problems in using the metal mold produced by molding or machining is microfabrication, which applies semiconductor microfabrication technology, to create a micropattern on a glass or silicon substrate by wet etching or dry etching. The wet etching, however, is not an accurate technique since the width (or diameter) accuracy degrades if a pattern height becomes 0.5 mm or more due to under etching at the bottom of a masking material.

The dry etching, on the other hand, is a technique developed from a patterning process of a silicon (Si) semiconductor, and its application to various electronic components and compound semiconductors using various plasma sources has been studied. Though the dry etching can create superior micropattern, its etching speed is as slow as 500 to 2, 000 nm/min., and it takes 50 minutes or more to create a pattern height of 0.1 mm, for example. The dry etching is thus not a productive, low-cost technique.

Besides, if the dry etching process time reaches one hour, system electrodes become heated, causing deformation of a substrate and damage to a device. Thus, when the system electrodes become as hot as more than 60°C, it is necessary to suspend the system operation and then restart the processing, which further decreases the productivity.

Another known processing technique to solve the above problems in using the metal mold produced by molding or machining is a lithography technique. The lithography technique applies resist coating to a substrate, exposes the resist layer, and creates a resist pattern by development. Then, this technique deposits a metal structure on the substrate in accordance with the resist pattern by electroplating, and produces a resin molded product using the metal structure as a mold.

The products produced by this process include optical disks having a structure with different heights of pits and grooves, such as Laser Disks, CD-ROMs, and Mini Disks, disclosed in Japanese Unexamined Patent Application Publication No. 2001-338444. This technique produces the structure with different heights of pits and grooves by creating different patterns on two different resist layers. This process can produce 50, 000 or more optical disks, for example, from one metal structure. Further, the lithography process enables accurate and low-cost production, thus being highly productive. This is preferred also in that a material to be processed by this technique is not silicon. However, the lithography process is applied only to the area of the optical disks and so on. It has thus not been achieved to produce accurate resinmolded products with various raised or recessed patterns used for material processing in the area significantly different from the above area, such as the clinical laboratory, combinatorial chemistry, and genetic fields.

Since the conventional optical disks have the pattern height of only about 1 to 3 µm, it is possible to obtain a given resist pattern in a development step. However, the inventors have found that, when creating a precise resist pattern with the pattern height of 5 µm or 30 µm and more, the resist pattern is dissolved or distorted during the development step, and it is difficult to create a given resist pattern. It is thus not possible to produce a metal structure and a resin molded product having a given pattern.

The lithography technique, and particularly, that uses synchrotron radiation as exposure light is disclosed in Japanese Unexamined Patent Application Publication No. 2001-38738. The synchrotron radiation is highly directional like laser light, and the short wavelength light, which cannot be produced by a laser, overcomes a diffraction limit that hampers the microfabrication. Thus, use of the synchrotron radiation as exposure light allows exposure of a thicker layer to create a fine and deep pattern compared to conventional exposure light.

However, it would be difficult to control the solubility of resist in the development step by using the synchrotron radiation.

The synchrotron radiation facilities are large scale, and installation and maintenance of the facilities are difficult. The costs for the facility installation and maintenance are very high. Further, the mask used for exposure is a special mask that absorbs the synchrotron radiation. A plurality of the special masks are needed to obtain a structure with different pattern heights, thus requiring further costs. Hence, a molded product produced by the injection molding costs several tens of times more than that produced by the normal lithography process.

A fuel cell combines oxygen and hydrogen to create water. There are five types of fuel cells, defined by the type of charge carrier and electrolyte. Conventional cells, primary cell and secondary cell, have an electrode and an electrolyte for interfacial reactions between the electrode and the electrolyte. The fuel cell, on the other hand, has a material channel to continuously supply material to the electrode.

For example, a cell is formed by the lamination of separators or electrodes having a through-hole (port) and a flow path (channel) for material supply. Material gas is supplied through the port, and current is generated by electrochemical reaction in the cell, thereby producing electricity.

The channel should be created on the separator or the electrode, and it is necessary to select the material having high corrosion resistance, high electrical conductivity, and thin, high rigidity. Though the size of the channel varies by type, 50 to 100 µm is considered proper for a direct methanol fuel cell (DMFC), which is under development for electric appliance applications. Channel members using a metal plate such as SUS and Ni, a silicon substrate with metal conducting coating, and a molded article of conductive carbon material such as conductive resin are now being developed. The smaller and thinner member is necessary to increase energy generation efficiency, and the microfabrication technology is required therefor.

As the process of producing a separator using a silicon substrate with metal conducting coating, a technique that creates a groove and a through-hole on a SiO₂ substrate by photolithography and then deposits a thin layer such as Au, Cr, and Pt to provide conductivity and durability is described in Mu Chiao, Kien B.Lam, and Liwei Lin, "MICROMACHINED MICROBIAL FUEL CELLS", IEEE International Micro Electro Mechanical Systems (MEMS), Kyoto Japan, 2003: pp. 383 - 386. This process allows producing an accurately formed separator. This process, however, requires performing resist coating, exposure, development, etching, and resist stripping for each substrate, and also uses an expensive silicon substrate. Thus, this process is not productive and has difficulty in reducing fuel cell costs.

As described in the foregoing, conventional processes are incapable of accurately producing a fuel cell separator having a multi-step pattern with high productivity.

In view of the foregoing, it is an obj ect of the present invention to provide a process for producing a resin molded product having a given shape or different pattern heights with high productivity and a process for producing a metal structure useful in the process.

It is another obj ect of the present invention to provide a resin molded product with a given pattern height, and particularly, a chip and a fuel cell channel member suitable for application in the clinical laboratory field, the genetic engineering field, and the combinatorial chemistry field.

The foregoing and other objects are achieved by the following. In the following descriptions, the order of the steps described below does not define the processing order unless otherwise indicated. The elements in each embodiment described below may be used in combination.

According to one aspect of the present invention, for achieving the above-mentioned object, there is provided a process of producing a resin molded product, including a step of forming a resist pattern on a substrate; a step of forming a metal structure by depositing a metal in accordance with the resist pattern on the substrate; and a step of forming a resin molded product by using the metal structure, wherein the step of forming a resist pattern includes a step of forming a plurality of resist layers on the substrate; and a step of developing the plurality of resist layers through solubility control in such a way that an upper resist layer has lower solubility in a developer than a lower resist layer. This process can prevent the deformation of the second resist layer pattern to produce a resin molded product with a given pattern. In this embodiment of the invention, the plurality of resist layers may be any number of layers more than one layer. This invention includes the case where three or more resist layers are formed. The lower resist layer and the upper resist layer are not necessarily directly laminated, and they may be separated. The deposition of the metal may be performed by various techniques, including plating. The metal structure may be used as a stamper or as an intermediate structure. This also applies to other aspects of the invention, unless otherwise specified.

In the above process of producing a resinmoldedproduct, the solubility control may include heat treatment control performed before the development step, for controlling amount of heat-treatment of the lower resist layer and the upper resist layer. This enables effective solubility control. The step of forming a resist pattern may include a step of performing heat-treatment of the lower resist layer before exposure of the lower resist layer; and a step of performing heat-treatment of the upper resist layer before exposure of the upper resist layer. This enables adjustment of the amount of heat in resist baking, for example. The lower resist layer and the upper resist layer may be made of resist of which solubility in a developer changes by exposure. The step of forming the resist patternmay include a step of performing heat-treatment of the lower resist layer after exposure of the lower resist layer; and a step of performing heat-treatment of the upper resist layer after exposure of the upper resist layer. The lower resist layer and the upper resist layer may be made of resist of which solubility in a developer changes by exposure and heat treatment. This enables adjustment of the amount of heat in heat treatment of chemical amplification resist, for example.

In the above process, the step of forming a resist pattern may include, before the development step, a step of exposing the lower resist layer; and a step of exposing the upper resist layer, and the solubility control may include exposure control for controlling amount of exposure of the lower resist layer and the upper resist layer. This enables effective solubility control. The lower resist layer and the upper resist layer may be made of resist of which solubility in a developer changes by exposure. The lower resist layer and the upper resist layer may be made of resist of which solubility in a developer changes by exposure and heat treatment.

In the above process, the lower resist layer and the upper resist layer may be made of resist of which solubility in a developer changes by exposure and heat treatment, and the step of forming a resist pattern may include, before the development step, a step of exposing the lower resist layer; a step of depositing the upper resist layer without performing heat treatment of the exposed lower resist layer; and a step of performing heat treatment of the upper resist layer after exposing the upper resist layer. This enables effective solubility control.

According to one aspect of the present invention, there is provided a process of producing a resin molded product having an uneven surface useful for material processing, including a step of forming a resist pattern on a substrate; a step of forming a metal structure by depositing a metal in accordance with the resist pattern on the substrate; and a step of forming a resin molded product by using the metal structure, wherein the step of forming a resist pattern includes a step of forming a plurality of resist layers on the substrate; and a step of developing a lower resist layer exposed with a mask pattern and an upper resist layer exposed with a mask pattern of the plurality of the resist layers, to form a resist pattern having a raised or recessed portion with a plurality of different heights. This process can create a raised or recessed pattern with a plurality of different heights used for material processing on a resin molded product.

In the above process of producing a resin molded product, a pattern of the lower resist layer and a pattern of the upper resist layer are preferably different. This allows effective creation of a raised or recessed pattern with different heights.

In the above process of producing a resin molded product, the step of forming a resist pattern may include a step of depositing a plurality of resist layers; and a step of exposing the plurality of resist layers at a time with an exposure mask or exposing each of the plurality of resist layers with an exposure mask of the same pattern, to form a pattern with a predetermined height. This enables creation of a resist layer having a raised or recessed pattern with a given height.

In the above process of producing a resin molded product, the step of forming a resist pattern may further include a step of depositing and exposing one or more resist layers after exposing the upper resist layer, to create a raised or recessed portion with two or more different heights.

In the above process of producing a resinmoldedproduct, the step of forming a resist pattern preferably forms a resist pattern having a raised or recessed portion with a plurality of different heights in one development step.

In the above process of producing a resin molded product, it is preferred to perform mask positioning to place a mask pattern used for exposure of the upper resist layer in the position corresponding to a mask pattern used for exposure of the lower resist layer. This enables accurate exposure.

In the above process of producing a resin molded product, it is preferred that the lower resist layer and the upper resist layer are made of different resist with different sensitivity. This enables more accurate patterning.

According to one aspect of the present invention, there is provided a process of producing a resin molded product having a groove with a width of 2 to 500 µm and an aspect ratio of 1 or more, and a through-hole, including a step of forming a metal structure; and a step of forming a resin moldedproduct, wherein the step of forming a metal structure includes a step of forming a first structure having an uneven surface; a step of forming a resist layer on the uneven surface of the first structure; a step of forming a resist pattern by forming a raised or recessed portion of the resist pattern on a raised portion of the uneven surface of the first structure, or by forming a recessed or raised portion of the resist pattern on a recessedportion of the uneven surface of the first structure; and a step of forming a second structure by depositing material for forming the second structure on the uneven surface of the first structure where the resist pattern is formed. This enables accurate production of a metal structure for a resin molded product. The aspect ratio is the ratio of the depth (height) to the width of a raised or recessed portion.

In the above process of producing a resin molded product, a light source used for exposure in the step of forming a resist pattern is preferably an ultraviolet lamp or a laser.

In the above process of producing a resin molded product, a height of a raised or recessed portion of a resin molded product formed by the step of forming a resin molded product is preferably substantially 5 µm to 500 µm. This enables production of a resin molded product suitable for material processing.

The above processes may produce a resin molded product having at least one of a channel pattern, a mixing part pattern, a reservoir pattern, an electrode, a heater, and a temperature sensor.

The above processes may produce a chip for clinical laboratory testing. Particularly, the chip may be selected one of a chip for blood testing, a chip for urine testing, and a chip for biochemical analysis.

The above processes may produce a chip for combinatorial chemistry. Particularly, the chip may be a chip for pharmaceutical development or a chip for chemical synthesis and analysis.

The above processes may produce a chip for genetic applications. Particularly, the chip may be a chip for gene amplification.

A channel member for a fuel cell according to the present invention is produced by the above processes. This enables production of low-cost channel member for a fuel cell.

According to one aspect of the present invention, there is provided a process of producing a metal structure for forming a resin molded product, including a step of forming a resist pattern on a substrate; and a step of forming a metal structure for forming a resin molded product by depositing a metal in accordance with the resist pattern on the substrate; wherein the step of forming a resist pattern includes a step of forming a plurality of resist layers; and a step of developing the plurality of resist layers on the substrate through solubility control in such a way that an upper resist layer has lower solubility in a developer than a lower resist layer. This process can prevent the deformation of the second resist layer pattern to produce a resin molded product with a given pattern.

According to one aspect of the present invention, there is provided a process of producing a metal structure for forming a resin molded product, having an uneven surface useful for material processing, including a step of forming a resist pattern on a substrate; and a step of forming a metal structure by depositing a metal in accordance with the resist pattern on the substrate; wherein the step of forming a resist pattern includes a step of forming a plurality of resist layers; and a step of developing a lower resist layer exposed with a mask pattern and an upper resist layer exposed with a mask pattern of the plurality of the resist layers, to form a resist pattern having a raised or recessed portion with a plurality of different heights. This process can create a raised or recessed pattern with apluralityof different heights useful for material processing on a resin molded product.

According to one aspect of the present invention, there is provided a process of producing a metal structure for forming a resin molded product, having a groove with a width of 2 µm to 500 µm and an aspect ratio of 1 or more, and a through-hole connected to the groove, including a step of forming a first structure having an uneven surface; a step of forming a resist layer on the uneven surface of the first structure; a step of forming a resist patternby forming a raised portion of the resist pattern on a raised portion of the uneven surface of the first structure, or by forming a recessed portion of the resist pattern on a recessed portion of the uneven surface of the first structure; and a step of forming a second structure by depositing material for the second structure on the uneven surface of the first structure where the resist pattern is formed. This enables accurate production of a metal structure for a resin molded product. The aspect ratio is the ratio of the depth (height) to the width of a raised or recessed portion.

The above and other objects, features and advantages of the present invention will become more fully understood from the detailed description given hereinbelow and the accompanying drawings which are given by way of illustration only, and thus are not to be considered as limiting the present invention.

Fig. 1A to 1H are pattern diagrams showing the steps of producing a resin molded product according to an embodiment of the present invention.

Fig. 2A is a top view of an example of a resin molded product produced by the steps of producing a resin molded product shown in Fig. 1A to 1H.

Fig. 2B is a side view of the resin molded product shown in Fig. 2A.

Fig. 3A is a top view of a resin molded product having a channel produced by the steps of producing a resin molded product shown in Fig. 1A to 1H.

Fig. 3B is a side view of the resin molded product shown in Fig. 3A.

Fig. 4A is a top view of a resin molded product having a channel produced by the steps of producing a resin molded product shown in Fig. 1A to 1H.

Fig. 4B is a side view of the resin molded product shown in Fig. 4A.

Fig. 5A is a top view of a resin molded product having a reservoir produced by the steps of producing a resin molded product shown in Fig. 1A to 1H.

Fig. 5B is a side view of the resin molded product shown in Fig. 5A.

Fig. 6A is a top view of a resin molded product having a reservoir produced by the steps of producing a resin molded product shown in Fig. 1A to 1H.

Fig. 6B is a side view of the resin molded product shown in Fig. 6A.

Fig. 7A is a top view of a resin molded product having a raised pattern produced by the steps of producing a resin molded product shown in Fig. 1A to 1H.

Fig. 7B is a side view of the resin molded product shown in Fig. 7A.

Fig. 8A to 8G are sectional views showing a process of producing a metal structure (or a stamper) according to the second embodiment of the present invention.

Fig. 9A to 9F are sectional views showing a process of producing a metal structure (or a stamper) according to the third embodiment of the present invention.

Fig. 10A to 10G are sectional views showing a process of producing a metal structure (or a stamper) according to the fourth embodiment of the present invention.

Fig. 11A to 11C are perspective views of examples of a resin molded product or a metal structure (or a stamper) for a resin molded product produced according to an embodiment of the present invention.

Fig. 12 is a perspective view showing the configuration of a separator or an electrode according to an embodiment of the present invention.

Fig. 13 is a perspective view showing another configuration of a separator or an electrode according to an embodiment of the present invention.

### EMBODIMENT 1

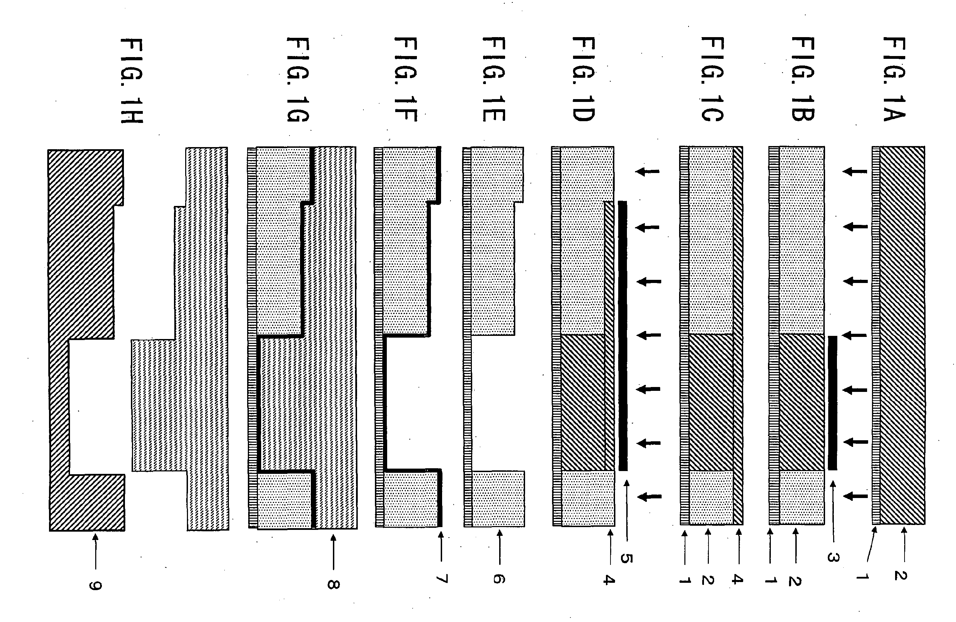

Referring first to Fig. 1A to 1H, the production process of a resin molded product according to an embodiment of the present invention is shown. This embodiment uses known production equipment, and its detailed explanation is omitted.

A production process according to this embodiment will be explained hereinafter with reference to Fig. 1A to 1H. Fig. 1A to 1H show a case that uses chemical amplification negative resist. This embodiment forms a resist pattern by the following steps:
(i) Formation of the first resist layer on a substrate (Fig. 1A)
(ii) Positioning of the substrate and a mask A (Fig. 1B)
(iii) Exposure of the first resist layer, with the mask A (Fig. 1B)
(iv) Heat treatment of the first resist layer (Fig. 1B)
(v) Formation of the second resist layer on the first resist layer (Fig. 1C)
(vi) Positioning of the substrate and the mask B (Fig. 1D)
(vii) Exposure of the second resist layer, with the mask B (Fig. 1D)
(viii) Heat treatment of the second resist layer (Fig. 1D)
(ix) Development of the resist layers (Fig. 1E)
A given resist pattern is thereby formed. The symbol allocated to each step does not correspond to the symbol in the figure. By depositing a metal on the substrate according to the resist pattern, a metal structure is formed. The preferred methods for the metal deposition are electroplating and electroless plating. A resin molded product may be produced by using the metal structure as a mold. Alternatively, the metal structure may be used as an intermediate structure in the formation of a mold to produce a resin molded product. For example, it is possible to form a metal mold by depositing a metal on the metal structurebyplating. Some of the above stepsmaybe omitted, depending on a resist material or a process used.

The resist pattern formation step in this embodiment will be explained in further detail below. For example, the creation of a structure having recessed or raised portions of 30 µm and 100 µm in heights on a substrate is as follows. Firstly, the first resist layer of 70 µm in thickness is deposited as a lower layer and then the second resist layer of 30 µm in thickness is deposited thereon an upper layer. Each layer is exposed or exposed and heat-treated. Then, the second resist layer is first developed to create the pattern with the height of 30 µm. The first resist layer is then developed, thereby creating the pattern with the height of 100 µm, which is the thickness of the first resist layer plus the thickness of the second resist layer. The inventors of this invention have found that it is important to control the solubility of each layer in a developer in order to avoid the dissolution or distortion of the 30 µm pattern of the second resist layer due to the developer when creating the 100 µm pattern.

As the thickness difference between the first and second resist layers become large, or the combined thickness of them increases, it is more important to control the solubility of each layer, and particularly, to reduce the solubility of the second resist layer, which is the upper layer, in a developer. The solubility of the second resist layer should be lower than that of the first resist layer, which is the lower layer. If the development step uses an alkaline developer, the second resist layer should be alkali resistant.

Each step will be explained hereinbelow.
(i) The formation of the first resist layer on a substrate will be explained.
   The flatness of the resin molded product obtained by the molded product formation step is determined by the step of forming the first resist layer 2 on the substrate 1. Thus, the flatness of the resist layer 2 when it is deposited on the substrate 1 is reflected in the flatness of the metal structure and the resin molded product eventually.
   The first resist layer 2 may be formed on the substrate 1 by any technique, including spin coating, dip coating, roll coating, and dry film resist lamination. The spin coating technique, which deposits resist on a spinning glass substrate, allows very flat coating of the resist on the glass substrate with the size of more than 300 mm in diameter. The spin coating is thus preferred for use to achieve high flatness.
   There are two types of resist that may be used: positive and negative. The depth of focus on the resist changes depending on resist sensitivity and exposure conditions. Thus, when using a UV exposure system, for example, it is preferred to adjust exposure time and UV output level according to the type, thickness, and sensitivity of the resist. It is preferred to use the negative resist since it has the higher pattern shape controllability. The negative resist changes the insolubility in a developer and allows effective control of the resist solubility, and it is thus particularly effective when creating a resist pattern with a great height. The negative resist is preferred also to prevent the distortion of the first resist pattern due to the solvent, such as thinner, contained in the second resist layer when forming the second resist layer 4 on the first resist layer 2 by the spin coating, for example.
   In the case of using wet resist, there are two ways for obtaining a given resist thickness by the spin coating, for example: a method of changing the spin coating rotation speed and a method of adjusting the viscosity. The method of changing the spin coating rotation speed yields a given resist thickness by setting the rotation speed of a spin coater. The method of adjusting the viscosity, on the other hand, adjusts the resist viscosity according to the flatness level required for practical use in order to avoid the degradation of the flatness which can occur when the resist is thick or the resist deposition area is large.
   When depositing a resist layer by the spin coating, for example, the thickness of the resist layer deposited at a time is preferably 50 µm or less to maintain high flatness. The first resist layer 2 is preferably 1 to 500 µm in thickness to produce the resin molded product for material processing. The resist coating may be repeated several times until a given resist layer thickness is reached. The formation of several resist layers is particularly effective for obtaining a given resist layer thickness while maintaining high flatness. These layers may be exposed together by one-time exposure performed later. It is also possible to create a deep-recessed portion in the first resist layer by forming another resist layer after the formation and exposure of one resist layer and exposing the layers with the same mask pattern.
   In the case of forming the resist layer by the spin coating, it is possible to control the solubility of the resist by adjusting the amount of resist baking (solvent drying), which is one of the heat-treatments. The baking is normally performed prior to the exposure of the resist. The baking may be performed with any equipment that can dry a solvent, including an oven, a hot plate, and a hot-air dryer. The amount of baking, which is one of the amount of heat-treatment, may be changed by controlling baking time or baking temperature. For example, by setting the amount of baking per volume of the first resist layer 2 to be smaller than that of the second resist layer 4, it is possible to control the solubility of the two resist layers. The control by the amount of baking may be applied to both the negative resist and the positive resist.
   If the first resist layer 2 is photo degradable positive resist, overbaking of the first resist layer 2 may harden the resist too much, making it difficult to dissolve an exposed part and create a pattern. Thus, it is preferred to adjust baking conditions by reducing the baking time and so on.
   The photodegradable positive resist and the chemical amplification positive resist may express lower alkali resistance than photo cross linkable negative resist. Hence, the combined thickness of the first and second resist layers is preferably 5 to 200 µm, and more preferably, 10 to 100 µm. If the materials of the first resist and the second resist are different, the solubility of the two resists may be different by the same amount of baking.
(ii) The positioning of the substrate and the mask A will be explained below.
   For a given positional relationship between the pattern of the first resist layer 2 and the pattern of the second resist layer 4, accurate positioning is necessary in the exposure step using the mask A 3.
   Positioning methods include a method of providing cutting in the corresponding positions of the substrate and the mask A and fixing them with pins, a method of reading the positions by laser interferometry, and a method of creating position marks in the corresponding positions of the substrate and the mask A and performing positioning by an optical microscope.
   The method of performing positioning by an optical microscope creates position marks on the substrate by photolithography technique, and on the mask A 3 by laser beam equipment, for example. This method is effective in that the accuracy within 5 µm can be easily obtained by manual operation using the optical microscope.
(iii) The exposure of the first resist layer with the mask A 3 will be explained below. The mask A 3 used in the step shown in Fig. 1B may be any type, including an emulsion mask and a chrome mask. In the resist pattern formation step, the sizes such as a flow channel width, height, a reservoir interval, width (or diameter), and height, and their accuracy are determined by the mask A used. The sizes and accuracy are reflected in the resin molded product.
   Hence, to obtain the resin molded product with given sizes and accuracy, it is necessary to specify the size and accuracy of the mask A. There are various techniques to increase the accuracy of the mask A 3. One technique is to use shorter wavelength laser light in the mask pattern formation, but it requires high facility costs, resulting in highermask fabrication costs. It is preferred to specify the mask accuracy according to the accuracy level required for practical use of the resin molded product.
   The material of the maskA 3 is preferably quartz glass in terms of temperature expansion coefficient and UV light transmission and absorption characteristics; however, since the quartz glass is relatively expensive, it is preferred to select the material according to the accuracy level required for practical use of the resin molded product. To obtain a structure with different pattern heights or a structure with different first resist pattern and second resist pattern, it is necessary to ensure the designing of the pattern, such as transmitting and shielding portions, of the masks used for the exposure of the first resist layer 2 and the second resist layer 4. An approach to achieve this is to perform simulation using CAE analysis software.
   The light used for the exposure is preferably UV light or laser light for low facility costs. Though the synchrotron radiation can make deep exposure, it requires high facility costs and thus substantially increases the cost of the resin molded product, being industrially impractical.
   Besides the optimization of the baking time, another method for developing the alkali resistance of photocrosslinkable negative resist is optimization of crosslink density. The crosslink density of the negative resist is normally adjusted by the exposure amount. Thus, adjustment of the amount of the exposure to the first resist layer 2 and that to the second resist layer 4 allows control of the solubility. The exposure amount may be adjusted by changing exposure time or exposure intensity. For example, by setting the exposure amount of the first resist layer 2 per volume to be smaller than that of the second resist layer 4, it is possible to make the solubility of the second resist layer 4 lower than that of the first resist layer 2. Since exposure conditions such as exposure time and intensity vary by material, thickness, and so on of the resist layer, they are preferably adjusted according to the pattern to be created. The adjustment of the exposure conditions is important because it affects the accuracy and the sizes of a pattern such as the width and height of a flow channel, and the interval, width (or diameter), and height of a reservoir. Further, since the depth of focus changes depending on the resist type, when using the UV exposure system, for example, it is preferred to adjust exposure time and UV output level according to the thickness and sensitivity of the resist. In the case of using the photocrosslinkable negative resist, the combined resist thickness is preferably 5 to 500 µm, and more preferably 10 to 300 µm.
(iv) The heat treatment of the first resist layer 2 will be explained below. A known heat treatment technique after the exposure is annealing to correct the shape of the resist pattern. The annealing is particularly used for chemical amplification resist to provide chemical crosslinking. Typical chemical amplification resist includes an acid generator as photosensitive material in the resist. The acid generated by the exposure induces reactions in the subsequent heat-treatment to enhance the solubility or insolubility of the resist in a developer. Particularly, the chemical amplification negative resist mainly comprises two- or three- component system. The terminal epoxy group of a chemical structure is ring-opened by exposure light and crosslinking reaction starts by the heat-treatment. If the layer thickness is 100 µm, the crosslinking reaction progresses in several minutes by the heat-treatment with the temperature of 100°C. When using the chemical amplification negative resist, the solubility can be controlled by adjusting the amount of the heat-treatment after the exposure, besides by adjusting the exposure amount. Alkali resistance is developed by increasing the exposure amount or the heat-treatment amount. The heat-treatment amount changes by treatment time or treatment temperature. Thus, by setting the heat-treatment amount of the first resist layer 2 per volume to be smaller than that of the second resist layer 4, it is possible to make the solubility of the first resist layer 2 higher than that of the second resist layer 4.
   Excessive heat-treatment of the first resist layer 2 makes it difficult to dissolve a non-crosslinked part to create a pattern in the subsequent development step. Thus, if the resist thickness is less than 100 µm, it is preferred to adjust the operation by reducing the heat-treatment time, performing the heat-treatment only after the second resist layer formation, and so on.
(v) The formation of the second resist layer 4 on the first resist layer 2 will be explained below. As shown in Fig. 1C, the second resist layer 4 is deposited on the first resist layer which has been exposed. The following is additional explanation of this step, besides the explanation given in the step (i). Adjustment of the amount of baking of the second resist layer allows control of the solubility of the second resist layer in a developer. The baking preferably uses hot air and applies heat from above. The alkali resistance can be developed by increasing heat-treatment time or heat-treatment temperature, for example. Particularly, in order that the second resist layer 4 has lower solubility than the first resist layer 2, the heat-treatment amount of the second resist layer 2 per volume should be larger than that of the first resist layer2. Forexample, it is possible to develop higher alkali resistance by increasing the baking time (solvent drying time) of the second resist layer 4 to harden the resist. The baking time of the resist is normally adjusted according to the thickness of layer, the density of solvent such as thinner, and the sensitivity. Increasing the baking time can enhance the alkali resistance. In the case of forming a positive resist layer by the spin coating, increasing the baking time about 1.5 to 2 times longer than usual enables development of the higher alkali resistance. It is thereby possible to prevent the dissolution or distortion of the second resist pattern at the completion of the development of the first and second resist layers.
(vi) The positioning of the substrate 1 and the mask B 5 will be explained below. The positioning is performed in the same manner as explained in the step (ii).
(vii) The exposure of the second resist layer 4 with the mask B 5 will be explained below. The second resist layer 4 is exposed by using the mask B 5 as shown in Fig. 1D. The mask B 5 has a different mask pattern from the mask A 3 so as to create an uneven pattern having a raised or recessed portion with a plurality of different heights. The exposure area of the second resist layer 4 is partly the same as but partly different from that of the first resist layers 2. A deeper pattern is created in the corresponding exposure area, for example.
   The exposure is performed in the same matter as explained in the step (iii) . The solubility of the resin can be controlled by adjusting the exposure amount of photocrosslinkable negative resist. Setting the exposure amount of the second resist layer 4 per volume to be larger than that of the first resist layer 2 makes the solubility of the second resist layer 4 lower than that of the first resist layer 2. This can prevent the dissolution or distortion of the resist pattern of the second resist layer 4.
(viii) The heat-treatment of the second resist layer 4 will be explained below. The following is additional explanation of this step, besides the explanation given in the step (iv). When using the chemical amplification resist, the solubility can be controlled by adjusting the amount of the heat-treatment after the exposure, such as treatment time and temperature, besides the exposure amount. By using the chemical amplification negative resist as the second resist layer and performing proper heat-treatment after the exposure, it is possible to control the resist solubility to avoid the dissolution or distortion of'the resist pattern of the second resist layer in the subsequent development step after the first resist layer pattern is created. The heat-treatment enhances the chemical crosslinking to increase the crosslink density, thereby developing the alkali resistance. The heat-treatment time for developing the alkali resistance is determined according to the resist thickness, preferably from the range of 1.1 to 2.0 times longer than usual, for example. Particularly, in order that the second resist layer has lower solubility than the first resist layer, the heat-treatment amount of the second resist layer 4 per volume should be larger than that of the first resist layer 2. As explained in the step (iv), the heat-treatment of the first resist layer 2 is not performed. The first resist layer 2 is heat-treated at the same time as the second resist layer 4. By performing the heat-treatment with hot air from above, it is possible to suitably adjust the heat-treatment amount of the second and first resist layers. Further, by performing the heat-treatment after the exposure to normal photo cross linkable negative resist or photo degradable positive resist of which solubility changes by the exposure, the solubility control is enabled. It has the same effect as the baking before the exposure. Thus, increasing the heat-treatment amount of the second resist layer allows decreasing the solubility of the resist layer in a developer.
(ix) The development of the resist layers will be explained below. The first resist layer 2 and the second resist layer 4 are developed in one developing step, thereby creating the pattern. The development step shown in Fig. 1E preferably uses a given developer suitable for the resist used. It is preferred to adjust development conditions such as development time, development temperature, and developer density according to the resist thickness and pattern shape. The adjustment of the development conditions is important since overlong development time causes the interval of patterns such as reservoirs and the width (diameter) of patterns such as reservoirs and channels to be larger than a given size, for example.

As the resist layer becomes thick, the width (or diameter) of the top surface of the resist may become undesirably larger than that of the bottom of the resist in the development step. Thus, when forming a plurality of resist layers, it is preferred in some cases to deposit different resists with different sensitivity in each resist layer formation step. In this case, the sensitivity of the resist layer close to the top is set higher than that of the resist layer close to the bottom. Specifically, BMR C-1000PM manufactured by TOKYO OHKA KOGYO CO., LTD. may be used as the higher sensitivity resist and PMER-N-CA3000PM manufactured by TOKYO OHKA KOGYO CO., LTD. may be used as the lower sensitivity resist. It is also possible to adjust the sensitivity by changing the drying time of the resist. For example, in the case of using BMR C-1000PM manufactured by TOKYO OHKA KOGYO CO., LTD., drying of the first resist layer for 40 minutes at 110°C and the second resist layer for 20 minutes at 110°C in a resist drying operation after the spin coating allows the first resist layer to have the higher sensitivity.

Methods to obtain a molded product with uniform accuracy and height of channels, mixing parts, reservoirs, and so on include a method of changing the type of resist (negative or positive) used in the resist coating, and a method of polishing the surface of a metal structure.

The techniques of adjusting the heat-treatment, the exposure, and so on, for the solubility control may be performed separately or in combination. The resist solubility control may be applied not only to the creation of an uneven pattern having different heights, but also to the creation of a uniform-level pattern having the same heights. Use of different materials with different characteristics for the first resist layer and the second resist layer allows the resist layers to have different sensitivity to the heat-treatment or the exposure. The resist layers can thereby have different solubility in a developer by the exposure or the heat-treatment under the same conditions.

Though the second resist layer is formed directly on the first resist layer in the embodiment explained above, the solubility control may be applied to any order or number of laminated layers. For example, to create a pattern having recessed portions with more than two different heights, it is possible to perform the resist coating and the exposure for each of the more than two resist layers according to the above explanation and then perform the development once to create the pattern. Use of differentmaskpatterns allows creation of the pattern having recessed portions with more than two different heights.

Now, the metal structure formation step will be explained in further detail hereinbelow. The metal structure formation step deposits a metal over the resist pattern 6 formed by the resist pattern formation step to form an uneven surface of a metal structure in accordance with the resist pattern, thereby obtaining the metal structure.

This step first deposits a conductive layer 7 in accordance with the resist pattern 6, as shown in Fig. 1F. Though any technique may be used for the formation of the conductive layer 7, it is preferred to use vapor deposition and sputtering. A conductive material used for the conductive layer 7 may be gold, silver, platinum, copper, or the like.

As shown in Fig. 1G, after forming the conductive layer 7, a metal is deposited in accordance with the pattern by plating, thereby forming a metal structure 8. Any plating method may be used for the deposition of the metal, including electroplating and electroless plating. Any metal may be used, including nickel, copper, and gold. Nickel is preferred since it is durable and less costly.

The metal structure 8 may be polished depending on its surface condition. In this case, to prevent contaminations from attaching to an molded product, it is preferred to perform ultrasonic cleaning after the polishing. Further, it is also possible to perform surface treatment of the metal structure 8 with mold release agent and so on, so as to improve the surface condition. The angle of gradient along the depth direction of the metal structure is preferably 50 to 90 degrees, and more preferably, 60 to 87 degrees. The metal structure 8 deposited by plating is then separated from the resist pattern.

The molded product formation step will now be detailed hereinbelow. The molded product formation step uses the metal structure 8 as a mold to form a resin molded product 9 as shown in Fig. 1H. Any technique may be used for the formation of the resin molded product 9, including inj ection molding, press molding, monomer casting, solution casting, and roll transfer by extrusion molding. The injection molding is preferred for its high productivity and pattern reproducibility. If the resin molded product is produced by the injection molding using the metal structure having a given size as a mold, it is possible to reproduce the shape of the metal structure with a high reproduction rate. The reproduction rate may be determined by using an optical microscope, a scanning electron microscope (SEM), a transmission electron microscope (TEM), and so on.

In the case of producing the resin molded product using the metal structure 8 as a mold by the injection molding, for example, 10, 000 to 50, 000 pieces or even 200, 000 pieces of resin molded products may be produced with one metal structure. It is thus possible to largely eliminate the costs for producing the metal structures. Besides, one cycle of the injection molding takes only 5 to 30 seconds, being highly productive. The productivity further increases with the use of a mold capable of simultaneous production of a plurality of resin molded products in one injection molding cycle. In this molded product formation step, the metal structure 8 may be used as a metal mold; alternatively, it maybe placed inside a prepared metal mold.

Any resin material may be used for the formation of the resin molded product, including acrylic resin, polylactide resin, polyglycolic acid resin, styrene resin, acrylic-styrene copolymer (MS resin), polycarbonate resin, polyester resin such as polyethylene terephthalate, polyamide resin, polyvinyl alcohol resin, ethylene-vinyl alcohol copolymer, thermoplastic elastomer such as styrene elastomer, vinyl chloride resin, and silicone resin such as polydimethylsiloxane. The above resin may contain one or more than one agent of lubricant, light stabilizer, heat stabilizer, antifogging agent, pigment, flame retardant, antistatic agent, mold release agent, antiblocking agent, ultraviolet absorbent, antioxidant, and so on.

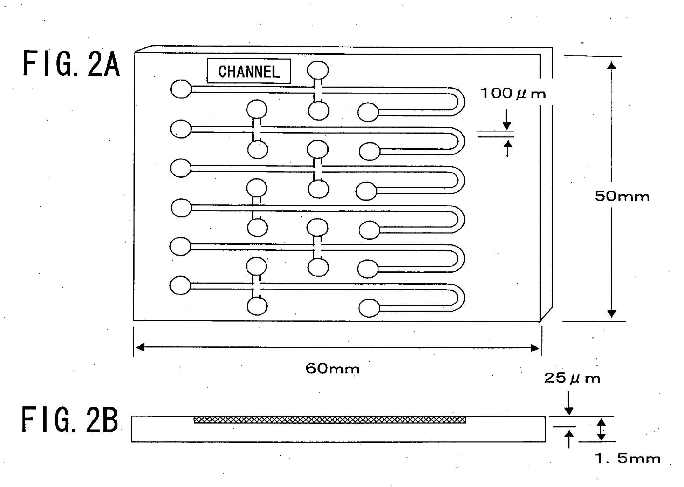

In the following, the resin molded product produced by the above process will be explained in detail. Figs. 2A and 2B show an example of the resin molded product produced by the production process according to this embodiment. The resin molded product in Figs. 2A and 2B has channels and mixing parts where the channels cross. The resin molded product further has a heater, a temperature sensor, and an electrode. The heater and the temperature sensor are placed on the channel. The electrode and a metal component such as the heatermaybe formedby sputtering or vapor deposition. The temperature sensor performs temperature control required for warming or reaction treatment. The sizes and accuracy of the resin molded product 9 are preferably adjusted in each step of the above process according to the level required for practical use.

The minimum width of the channel of the resin molded product 9 depends on the processing accuracy of the mask. In terms of industrial technology, the minimization would be possible with the use of a short wavelength laser such as a X-ray laser. However, since this invention aims at offering accurate and low-cost resin molded products widely for the medical, industrial, and biotechnological fields, which are particularly suitable for a chip useful in the clinical laboratory, combinatorial chemistry, and genetic engineering fields, the minimum width of the channel is preferably 5 µm to enable easy industrial reproduction. Further, in application to unstandardized resin molded products of multi-kind small lot also, the width of the channel is preferably 5 µm or above to offer the product as an accurate and low-cost reservoir. The maximum width of the flow channel is not limited; however, the width is preferably 300 µm or less to enable shorter diagnosis time andparallelprocessing, andprovide portability to a system.

The minimum height of the channel of the resin molded product 9 is preferably 5 µm to function as a channel. The maximum height of the channel, on the other hand, is not limited. The channel height, however, is preferably 300 µm or less, and more preferably, 200 µm or less, to preserve the effects of reducing the channel width, such as reducing diagnosis time, enablingparallelprocessing, andproviding portability to a system when used in chemical analysis, DNA diagnosis, and so on.

The minimum length of the channel of the resin molded product 9 is preferably 5 mm to allow sample injection and separation (analysis). The maximum length of the channel, on the other hand, is not limited. The channel length, however, is preferably 300 µm or less to preserve the effects of reducing the channel length, such as reducing diagnosis time, enabling parallel processing, and providing portability to the system when used in chemical analysis, DNA diagnosis, and so on.

The minimum interval of the reservoirs of the resin molded product 9 depends on the processing accuracy of the mask. In terms of industrial technology, the minimization would be possible with the use of a short wavelength laser such as a X-ray laser. However, since this invention aims at offering accurate and low-cost reservoirs widely for the medical, industrial, and biotechnologicalfields, which are particularly suitable for a chip useful in the clinical laboratory, combinatorial chemistry, and genetic engineering fields, the minimum interval of the reservoirs is preferably 5 µm to enable easy industrial reproduction.

In some cases, the minimum interval of the reservoirs is determined by the positioning accuracy of the blood test system, for example. It is thus preferred to select the minimum reservoir interval according to system specifications. Further, in application to unstandardized molded products of multi-kind small lot also, the reservoir interval is preferably 5 µm or above to offer the product as an accurate and low-cost reservoir. The maximum interval of the reservoirs is not limited; however, the reservoir interval is preferably 10, 000 µm or less to allow parallel processing and provide portability to a system.

For the same reasons, the preferable range of the width (or diameter) of the reservoir of the resin molded product 9 is also between 5 µm to 10,000 µm. The minimum height of the reservoir of the resin molded product 9 is not limited, but it is preferably 10 µm to function as a reservoir. As for the maximum height of the reservoir, it would be possible to obtain a deeper pattern by means of performing a plurality of resist coating steps, using laser light such as X-ray beam as exposure light to ensure enough depth of focus, and so on. However, since this invention aims at offering accurate and low-cost reservoirs widely for the medical, industrial, and biotechnological fields, the maximum reservoir height is preferably 1,000 µm to enable easy industrial reproduction.

The flatness of the resinmoldedproduct 9 is preferably 1 µm or more to enable easy industrial reproduction. The flatness of the resin molded product 9 is preferably 200 µm or less in order not to cause a problem in the attachment of the molded product to another substrate. The dimensional accuracy of the width and height of the channel of the resin molded product 9 is preferably within the range of ± 0.5 to 10% to enable easy industrial reproduction. The dimensional accuracy of the interval, width (or diameter) and height of the reservoir of the resin molded product is preferably within the range of ± 0.5 to 10% to enable easy industrial reproduction.

The dimensional accuracy of the thickness of the resin molded product 9 is preferably within the range of ± 0.5 to 10% to enable easy industrial reproduction. The thickness of the resin molded product 9 is not particularly specified, but it is preferably within the range of 0.2 to 10 mm to prevent breakage at removal in the inj ection molding, or breakage, deformation, or distortion during operation. The size of the resinmoldedproduct 9 is also not particularly specified, and it is preferably selected according to usage. For example, when forming the resist pattern by the lithography technique, if the resist layer is formed by spin coating, the molded product size is preferably within 400 mm in diameter.

The resin molded product obtainable by the process according to the present invention is particularly effective for medical applications including DNA diagnosis, a sample reservoir, an antibody reservoir, and a reagent reservoir, industrial applications including an optical front plate, biotechnological applications such as cell processing, and automated chemical analysis including a reaction reservoir. The present invention is applicable to the production of a resin molded product with a plurality of raised or recessed patterns with different heights, used for material processing in the above or other areas.

In application to the medical field, particularly for use that requires biocompatibility such as antithrombogenicity (antiplatelet adhesion) and elimination of harmful effect in cytotoxicity testing, it is preferred to use amaterial having antithrombotic effects or conduct surface treatment. An example of the technique to improve the biocompatibility by the surface treatment is to deposit a SiO₂ layer by sputtering on the molded product produced by the inj ection molding, and then develop the SiO₂ layer by thermal oxidation, thereby providing the biocompatibility to the product.

When the resin molded product is used in the medical field, particularly in the clinical laboratory field, for the biochemical analysis, the DNA diagnosis, and so on, it is sometimes necessary to perform operations such as warming, reaction, and signal detection on the resin molded product. The warming or the reaction treatment may be performed on the resin molded product by forming an electrode pattern by sputtering to apply a voltage from the system, or by providing a heater. If the warming or the reaction treatment requires temperature control, a temperature sensor may be provided, for example. The signal detection may be performed by providing photodiode.

When used in the medical field, particularly in the clinical laboratory field, for the biochemical analysis, the DNA diagnosis, and so on, a molded product preferably has a miniaturized channel to reduce diagnosis time. Such a molded product can be achieved by the resin molded product obtainable by the present embodiment of the invention. The resinmoldedproduct according to this embodiment is accurate and low cost, thereby being effective for heavy-use applications such asbiochemicalanalysisand DNA diagnosis, particularly at an operating room, bedside, home, local clinic, and so on.

The resinmoldedproduct 9 according to this embodiment is accurate and low cost. Thus, it does not cost much to discard it and use a new one in the occurrence of defects such as contaminated surface and distortion, though a repeated use is also possible. The resin molded product is therefore particularly effective for applications that require high operating efficiency with reduced labor and time and so on. Since the resin molded product 9 according to this embodiment is accurate and low cost, besides the medical, industrial, biotechnological fields, it is also widely applicable to the field of the automated chemical analysis such as combinatorial chemistry. Particularly, the smaller sample requirements achieved by the resin molded product 9 allow significant reduction of waste solution, thus being effective in terms of environmental preservation as well.

When producing themetal structure and the resin molded product by the process according to the present invention, the surface of the first resist layer may be slightly distorted within several µm or the edge of the pattern of the first resist layer may be inclined due to formation of the second resist layer over the first resist layer; however, they cause no practical problem.

The resin molded product produced by the process according to this embodiment has higher accuracy and so on than conventional molded products. In addition to being accurate, this resin molded product is low in production cost. It is thus particularly effective for heavy-use applications to take maximum advantage of the minimum production costs.

### EXAMPLE

The process for producing a resin molded product according to the present invention will be explained hereinafter with reference to the drawings. Referring first to Fig. 1A, the first resist coating was performed on a substrate, using an organic material (PMER N-CA3000PM manufactured by TOKYO OHKAKOGYO CO., LTD.). Referring then to Fig. 1B, after the first resist layer formation, positioning of the substrate and a mask A patterned with given reservoirs was performed.

After that, the first resist layer was exposed to UV light from a UV exposure system (PLA-501F manufactured by CANON INC. with the wavelength of 365 nm and the exposure dose of 300 mJ/cm²). The first resist layer was then heat-treated, using a hot plate at 100°C for 4 minutes.

Referring then to Fig. 1C, the second resist coating was performed on the substrate, using an organic material (PMER N-CA3000PMmanufactured by TOKYOOHKAKOGYOCO., LTD.). Referring then to Fig. 1D, after the second resist layer formation, positioning of the substrate and a mask B patterned with given reservoirs was performed.

After that, the second resist layer was exposed to UV light from a UV exposure system (PLA-501F manufactured by CANON INC. with the wavelength of 365 nm and the exposure dose of 100 mJ/cm²) . The second resist layer was then heat-treated, using a hot plate at 100°C for 8 minutes.

Referring then to Fig. 1E, development was performed on the substrate having the resist layers, thereby creating a resist pattern on the substrate, using PMER developer P-7G manufactured by TOKYO OHKA KOGYO CO., LTD.

Referring now to Fig. 1F, vapor deposition or sputtering was performed on the substrate with the resist pattern, thereby depositing a conductive layer formed of silver on the surface of the resist pattern. Platinum, gold, copper, or the like may be deposited instead of the silver in this step.

Referring then to Fig. 1G, the substrate having the resist pattern was immersed in a plating solution for electroplating to form a metal structure (hereinafter referred to as a Ni structure) in gaps in the resist pattern. Alternatively, copper, gold, or the like may be deposited in this step.

Referring finally to Fig. 1H, a plastic material was filled in the Ni structure, which serves as a mold, by injection molding. A plastic molded product was thereby produced.

### EXAMPLE 1 - Production of a molded product having a channel

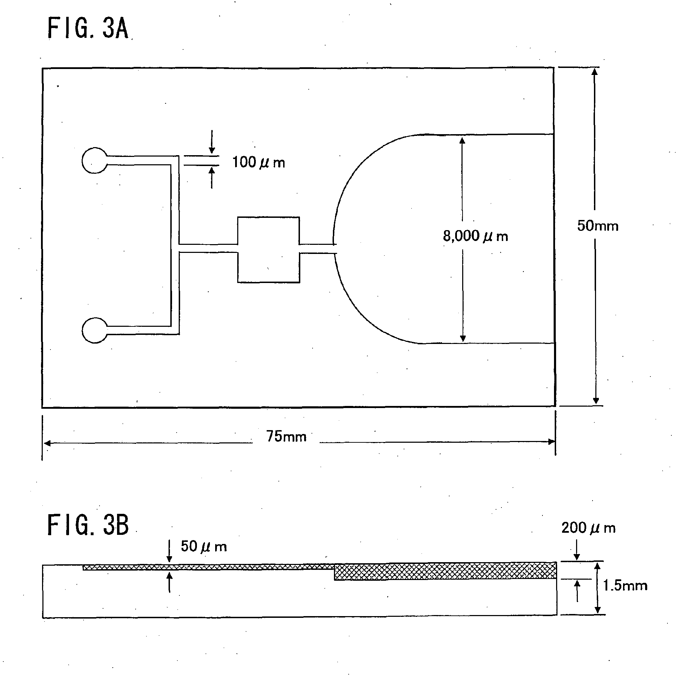

According to the molded product production process shown in Fig. 1A to 1H, resist coating was repeated two times to form the first resist layer and then exposure and heat-treatment were performed thereon. Further, the resist coating was performed once again to form the second resist layer, and then the exposure and the heat-treatment were performed thereon. A resin molded product, as shown in Figs. 3A and 3B, having a substrate with 75 mm in width, 50 mm in length, and 1.5 mm in thickness on which a channel with 50 µm and 200 µm in heights was created was thereby produced.

### EXAMPLE 2 - Production of a molded product having a channel

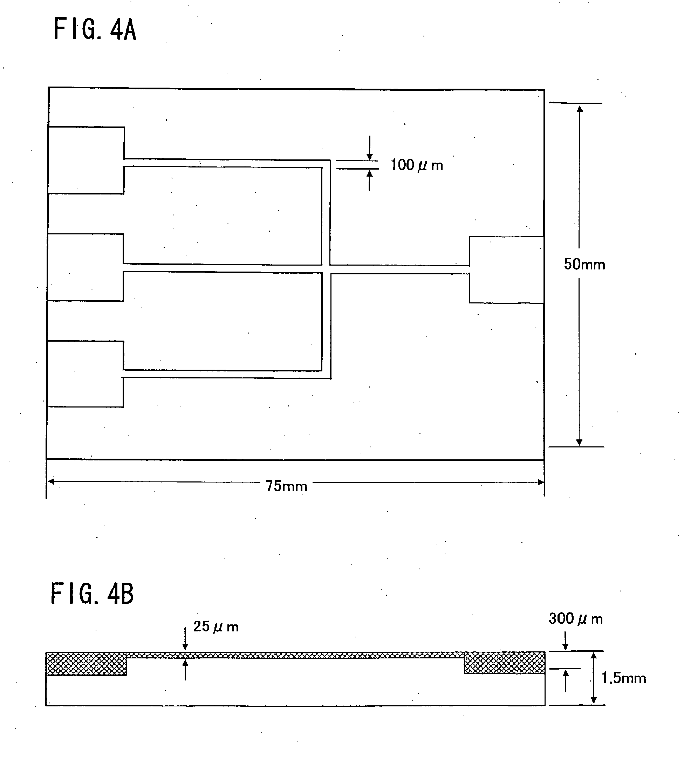

According to the molded product production process shown in Fig. 1A to 1H, resist coating was repeated three times to form the first resist layer and then exposure and heat-treatment were performed thereon. Further, the resist coating was performed once again to form the second resist layer, and then the exposure and the heat-treatment were performed thereon. Aresinmoldedproduct, as shown in Figs. 4A and 4B, having a substrate with 75 mm in width, 50 mm in length, and 1.5 mm in thickness on which a channel with 25 µm and 300 µm in heights was created was thereby produced.

### EXAMPLE 3 - Production of a molded product having a reservoir

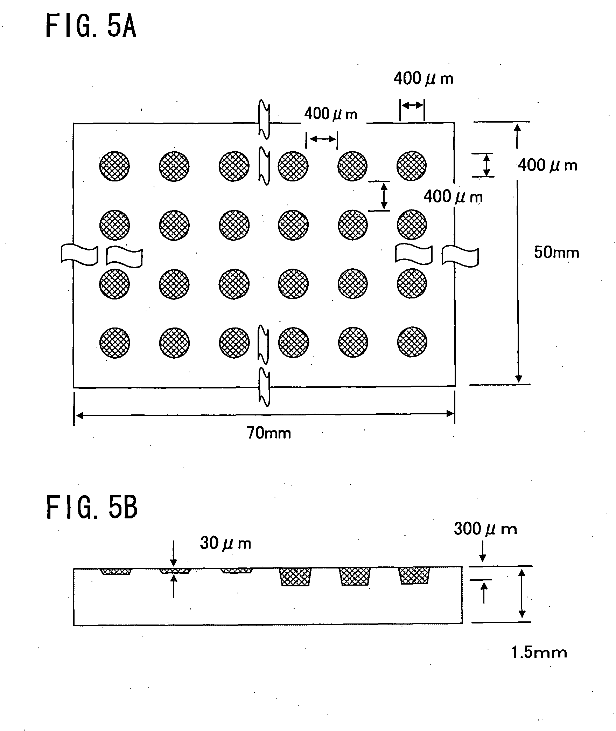

According to the molded product production process shown in Fig. 1A to 1H, resist coating was repeated three times to form the first resist layer and then exposure and heat-treatment were performed thereon. Further, theresist coating was performed once again to form the second resist layer, and then the exposure and the heat-treatment were performed thereon. A resin molded product, as shown in Figs. 5A and 5B, having a substrate with 75 mm in width, 50 mm in length, and 1.5 mm in thickness on which reservoirs with 30 µm and 300 µm in heights were created was thereby produced.

### EXAMPLE 4 - Production of a molded product having a reservoir

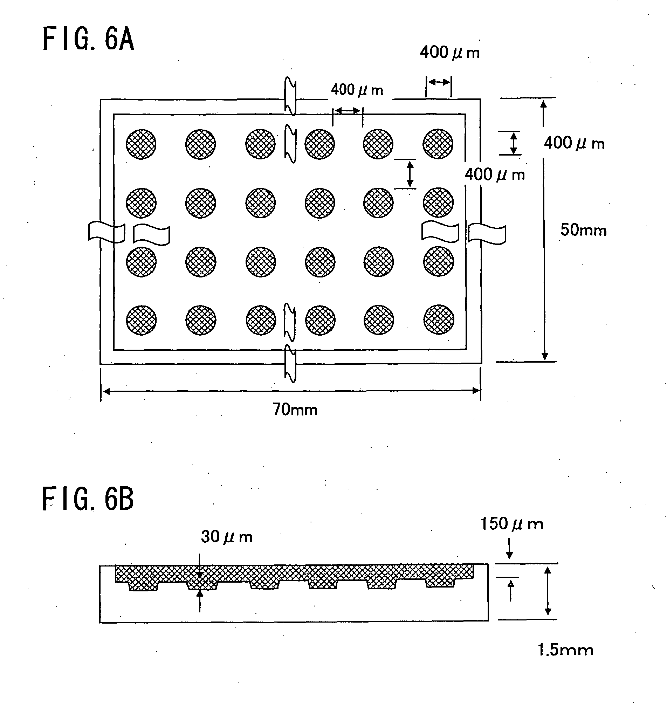

According to the molded product production process shown in Fig. 1A to 1H, resist coating was performed once to form the first resist layer and then exposure and heat-treatment were performed thereon. Further, the resist coating was repeated two times to form the second resist layer, and then the exposure and the heat-treatment were performed thereon. A resin molded product, as shown in Figs. 6A and 6B, having a substrate with 70 mm in width, 50 mm in length, and 1.5 mm in thickness, having a recessed portion with 150 µm in height on which a reservoir with 30 µm in height was created at the bottom was thereby produced.

### EXAMPLE 5 - Production of a molded product having a raised pattern

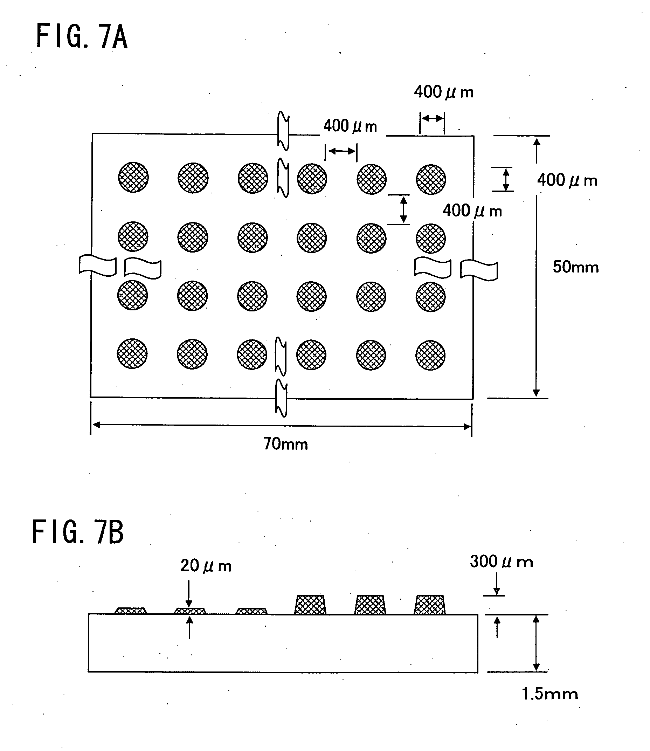

According to the molded product production process shown in Fig. 1A to 1H, resist coating was performed once to form the first resist layer and then exposure and heat-treatment were performed thereon. Further, the resist coating was repeated three times to form the second resist layer, and then the exposure and the heat-treatment were performed thereon. A resin molded product, as shown in Figs. 7A and 7B, having a substrate with 75 mm in width, 50 mm in length, and 1.5 mm in thickness, on which raised patterns with 20 µm and 300 µm in heights were created was thereby produced. This pattern may be perceived as having recessed portions with 20 µm and 300 µm in heights.

### EMBODIMENT 2

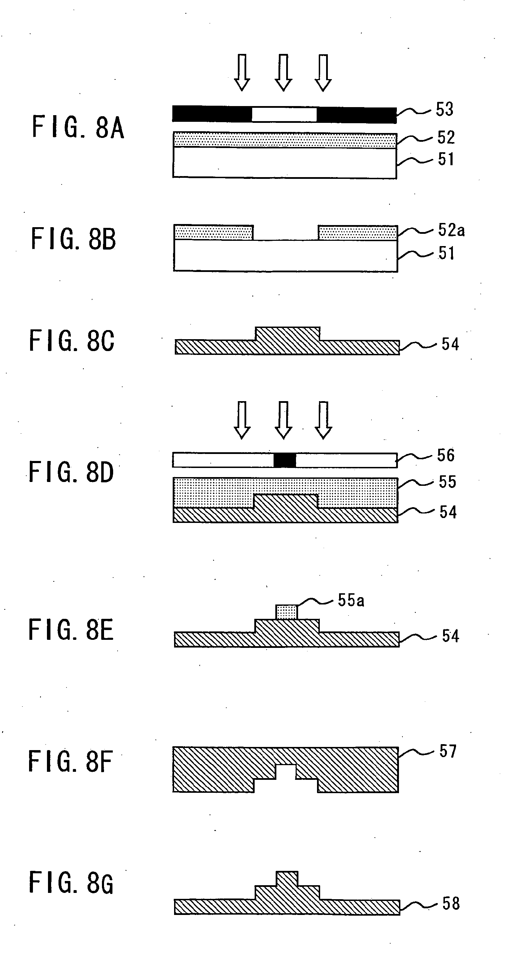

The production process of a metal structure (or a stamper) and a resin molded product according to another embodiment of the present invention will be explained hereinafter with reference to Fig. 8A to 8G. Fig. 8A to 8G are sectional views showing the production process of the metal structure (or the stamper) according to this embodiment. The stamper is an example of the metal structure. Reference numeral 51 designates a substrate, 52 the first resist layer, 53 the first layer mask, 54 the first intermediate structure, 55 the second resist layer, 56 the second layer mask, 57 the second intermediate structure, and 58 a metal structure or a stamper, which is an example of the metal structure. The same steps as the first embodiment are performed in the same manner as explained above, and redundant explanation will be omitted.

The step of resist coating will be explained below. Firstly, the first resist layer 52 is deposited on the substrate 51, using an organic material (AZP4400 manufactured by CLARIANT JAPAN K.K., for example). The resist layer 52 is formed of positive photoresist, in which a light-exposed area is soluble in a developer. The substrate 51 is, for example, a glass substrate. The flatness of a resin molded product is significantly affected by the step of forming the resist layer on the substrate. Thus, the flatness when the resist layer is formed on the substrate is reflected in the flatness of the metal structure (stamper) and the resin molded product eventually.

One way to maintain high flatness is to perform development until the substrate surface is revealed. If the substrate is a glass, an established industrial technique enables the flatness to be within 1 µm by surface grinding. By performing the development until revealing the substrate surface, the same flatness is obtained, thereby increasing the flatness.

One technique to form the resist layer 52 on the substrate 51 is spin coating. The spin coating technique, which deposits resist on a spinning substrate, allows very flat coating of the resist on the substrate with the size of more than 300 mm in diameter. To obtain a given resist thickness by the spin coating, increasing a resist viscosity is effective, but it can degrade the flatness when a deposition area is large. It is thus preferred to adjust the resist viscosity according to the flatness level required for practical use.

The thickness of the first resist layer is preferably 2 to 500 µm, and more preferably, 20 to 50 µm to maintain the high flatness, considering the exposure depth of an exposure system. The resist thickness corresponds to the height of the step on the surface of the metal structure (stamper) and the resin molded product which will be formed later. Besides the spin coating, the resist layer formation techniques include dip coating, roll coating, and dry film resist lamination. The spin coating, however, is preferred for use to obtain high flatness. The resist layer may be formed by one resist coating step or more than one resist coating steps.

The step of exposing the resist layer 52 will be explained below. After deposited, the first resist layer 52 is exposed to UV light from a UV exposure system, using the mask 53 with a given mask pattern, as shown in Fig. 8A. In the illustration, a white part of the mask 53 lets light through while the black part blocks light. The UV exposure system, for example, has a UV lamp as a light source, with the wavelength of 365 nm and the illumination intensity of 20 mW/cm². In the exposure of the resist, the depth of focus on the resist changes depending on exposure conditions. Thus, when using the UV exposure system, for example, it is preferred to adjust the wavelength, exposure time, and UV output level according to the thickness and sensitivity of the resist. The exposure system may be a system using a UV laser. The UV laser can make the deeper exposure than UV lamp.

In the step of patterning the resist layer 52 by lithography technique, the pattern width and height, and their accuracy are determined by the mask used and exposure conditions. The sizes and accuracy are reflected in the resinmoldedproduct. Thus, to obtain aplastic resinmolded product having given sizes and accuracy, it is necessary to specify the sizes and accuracy of the mask. Any type of mask may be used, including an emulsion mask and a chrome mask. The chrome mask is preferred to obtain fine pattern accuracy.

The step of developing the first resist layer 52 will be explained below. As shown in Fig. 8B, the resist layer 52 on the substrate 51 is developed until the substrate surface is revealed, thus forming a resist pattern 52a on the substrate 51. A raised portion is thereby created on the flat and smooth substrate. A developer may be AZ400K developer manufactured by CLARIANT JAPAN K.K., for example. When creating the resist pattern by the lithography technique, it may be required to adjust the concentration of the developer, which is an alkaline solution, and the developing time. Particularly, in the case of developing the resist until the substrate 51 is revealed, the width (or diameter) of the top surface of the resist may become undesirably larger than that of the bottom of the resist. To prevent this, it is possible to control the development by raising the dilution ratio of the developer and reducing the developing speed to optimize the developing time.

The rectangular pattern along the pattern depth direction may be a selected one of a trapezoidal shape and a vertical shape. It is preferred to select the pattern shape depending on a given pattern, accuracy, and mold release characteristics when molding plastics by injection molding.

The steps of conductivity providing and electroforming to form the first intermediate structure 54 will be explained below. Plating technique may be used to deposit a metal for the formation of the first intermediate structure 54. The plating method for the metal deposition includes electroplating and electroless plating. In the step of providing conductivity, vapor deposition or sputtering is performed on the substrate 51 having the resist pattern 52a, thereby depositing Ni as a conductive plating layer on the surfaces of the resist pattern 52a and the substrate 51. In this step, Pt, Au, Ag, Cu, Al, or the like may be deposited instead of Ni.

In the electroforming step, the substrate 51 having the resist pattern 52a is immersed in a plating solution for electroplating to deposit Ni on the resist pattern and the substrate, thereby forming the first intermediate structure 54. In this step, Cu, Au, or the like may be deposited instead of Ni. Then, the resist is dissolved away by a solvent such as an acetone or nitrate solution, thus separating the first intermediate structure 54 from the substrate 51. The first intermediate structure 54 has the inverse pattern of the substrate 51, in which the substrate pattern is transfer-printed, as shown in Fig. 8C.

Instead of the electroplating, electroless plating may be used for the deposition of the metal layer. In the electroless plating, first, a catalyst metal such as Pd-Sn complex, which serves as an electroless plating corematerial, is attached as a plating layer to the surface of an object. Then, tin salt on the obj ect surface is dissolved to generate metal palladium by a redox reaction. The object is then immersed in a Ni plating solution and a Ni layer is thereby formed on the object. This is the same in the plating performed later.

Though the first intermediate structure is formed with the metal in the above explanation, it is also possible to form it with resin by close-contacting or press-molding of a transfer body made of resin and so on. The resin used for the close-contacting or the press-molding of the transfer body may be thermosetting resin or photosetting resin, and the resin may be hardened after the pattern transfer.

The step of forming a resist pattern on the first intermediate structure 54 will be explained below. This step also performs patterning by the lithography technique. The second resist layer 55 is deposited on a transfer surface of the first intermediate structure 54, using an organic resin material. In this step, the same resist layer as the resist layer 52 is deposited in the same conditions. After that, mask positioning is performed to place the second layer mask 56 in the position corresponding to the first layer mask 53 in the first exposure. Then, the second exposure is performed on the resist layer 55, using the second layer mask 56, with UV light from the UV exposure system. The first layer resist pattern and the second layer resist pattern are thereby formed with high accuracy.

The positioning of the mask will be explained below. The mask positioning is performed to place a mask pattern to be printed on the secondresist layer 55 in the same position as the mask pattern printed on the first resist layer 52. If the mask positioning step fails to place the mask pattern to be printed on the second resist layer 55 in the same position as the mask pattern printed on the first resist layer 52, it seriously affects the pattern accuracy of the metal structure (stamper) and the resin molded product. Hence, positioning error is preferably within the range of ± 20 µm, and more preferably, within the range of ± 1 µm.

Various techniques may be used to increase the accuracy of the mask positioning, including offset adjustment that uses the difference of light diffraction between an exposed part and a non-exposed part. Another technique to increase the mask positioning accuracy is to draw a mark on a specific location of the substrate and the mask by laser light and thereby adjust their positions using an optical microscope and so on. Further, since a mask aligner and so on may be used, it is preferred to make an alignment mark in the corresponding positions of the first layer mask 53 and the second layer mask 56.

The exposure of the second layer is performed in the same exposure conditions as the exposure of the first layer. Since the depth of focus on the resist changes, when using the UV exposure system, for example, wavelength, exposure time, and UV output level may be adjusted according to the resist thickness and sensitivity.

Then, the second resist layer 55 formed on the first intermediate structure 54 is developed until the first intermediate structure 54 is revealed, thereby creating the second resist pattern 55a as shown in Fig. 8E. The raised (or recessed) pattern with two steps is thereby created. This embodiment exposes the second resist layer 55 except the resist above a part of the raised portion of the first intermediate structure 54. Thus, while the exposed part of the second resist layer 55 is removed by the development, the unexposed part of the resist is left on the first intermediate structure 54. The second-step raised portion is thereby formed on the first-step raised portion, as shown in Fig. 8E. The first intermediate structure 54 thus has a multi-step pattern with a two different steps.

The steps of providing conductivity and electroforming onto the uneven surface of the first intermediate structure 54 will be explained below. The sputtering or the vapor deposition is performed on the surface of the first intermediate structure 54 having the resist pattern 55a, thereby depositing Ni as a plating layer on the resist pattern 55a. In this step, Pt, Au, Ag, Cu, Al, or the like may be deposited instead of Ni.

Then, the first intermediate structure 54 having the second resist pattern 55a is immersed in a plating solution for electroplating. Ni is thereby deposited on the first intermediate structure 54 with the second resist pattern 55a, thereby forming the second intermediate structure 57. The pattern of the first intermediate structure 54 with the resist pattern 55a is transferred to the second intermediate structure 57. In this step, Cu, Au, or the like may be deposited instead of Ni. After that, the first intermediate structure 54 and the resist pattern 55a are removed to obtain the second intermediate structure 57. Further, the electroforming is performed in the same manner on the second intermediate structure 57, thereby forming the metal structure (stamper) 58. In this step, oxidation treatment is provided on the surface of the second intermediate structure 57. The pattern of the second intermediate structure 57 is thereby transferred, as shown in Fig. 8G, producing the metal structure (stamper) 58, made of Ni, having a multi-step pattern with a plurality of pattern heights.

The step of molding resin by using the metal structure (stamper) 58 will be explained hereinafter. Technique that may be used for the formation of the resin molded product includes injection molding, press molding, monomer casting, solution casting, and roll transfer by extrusion molding. The inj ection molding is preferred for its high productivity and pattern reproducibility. By producing the resin molded product by the injection molding using the metal structure having a given size as a mold, it is possible to reproduce the pattern of the metal structure with a high reproduction rate. A plastic material is filled in the metal structure (stamper) 58 as a mold by injection molding, thus obtaining a resin molded product. A plastic material that may be used for the formation of the resinmoldedproduct by the injection molding includes acrylic resin, polylactide resin, polyglycolic acid resin, styrene resin, acrylic-styrene copolymer (MS resin) , polycarbonate resin, polyester resin such as polyethylene terephthalate, polyamide resin, ethylene-vinyl alcohol copolymer, and vinyl chloride resin. The above resin may contain one or more than one agent of lubricant, light stabilizer, heat stabilizer, antifogging agent, pigment, flame retardant, antistatic agent, mold release agent, antiblocking agent, ultraviolet absorbent, antioxidant, and so on.
As the resist becomes thick, it is sometimes not possible to obtain sufficient depth of focus with one-time exposure when using the UV exposure system, for example. Thus, the process in this embodiment forms the intermediate structure with a raised (or recessed) portion and then deposits resist over the raised portion. It is thereby possible to create a groove that is equivalent to the one created by two times of lithography processes, allowing the creation of a deeper pattern. By repeating this process several times according to need, it is possible to accurately produce the resin molded product with a given pattern height. Since this embodiment applies exposure light to one resist layer only, it allows accurate production regardless of the depth of focus.

In the course of creating a fine resist pattern with a given resist thickness, the resist may shrink due to repeated exposure and resist pattern creation, causing the substrate to have uneven flatness or pattern height. The surface profile of the resist is reflected in the intermediate structure, the metal structure (stamper), and eventually the resin molded product produced by the final step. Thus, in order to obtain the uniform flatness and pattern height, the present embodiment performs the first resist coating on the substrate, the resist layer exposure, and the resist pattern formation, then forms the first intermediate structure 54, and further performs the second resist coating thereon. The exposure and the development of each resist layer is performed only once, and it is not necessary to perform a plurality of exposure or development on the resist layer. It is thus possible to suppress the degradation of the resist layer that causes the errors in the resin molded product.

The resin molded product production process according to this embodiment uses positive resist for the first resist layer 52 . Thus, if the second resist layer is formed directly on the first resist pattern 52a, the first resist pattern 52a may be also exposed in the second layer exposure step, causing the deterioration of the first resist pattern 52a. If the first resist pattern 52a is deteriorated, the first resist layer 52 can dissolve in the subsequent development step, leading to the pattern deformation. To avoid this, by forming the first intermediate structure 54 after forming the first resist pattern 52a on the substrate 51, it is possible to accurately form the pattern with two or more steps and accurately produce the metal structure (stamper) 58 having the deeper pattern than the pattern height of the first intermediate structure 54. Use of this metal structure (stamper) 58 allows producing the resin molded product with high productivity. The production process of the resin molded product described above can accurately produce the resin molded product with the pattern where the height of one layer is approximately 2 to 500 µm and the width is approximately 2 to 500 µm.

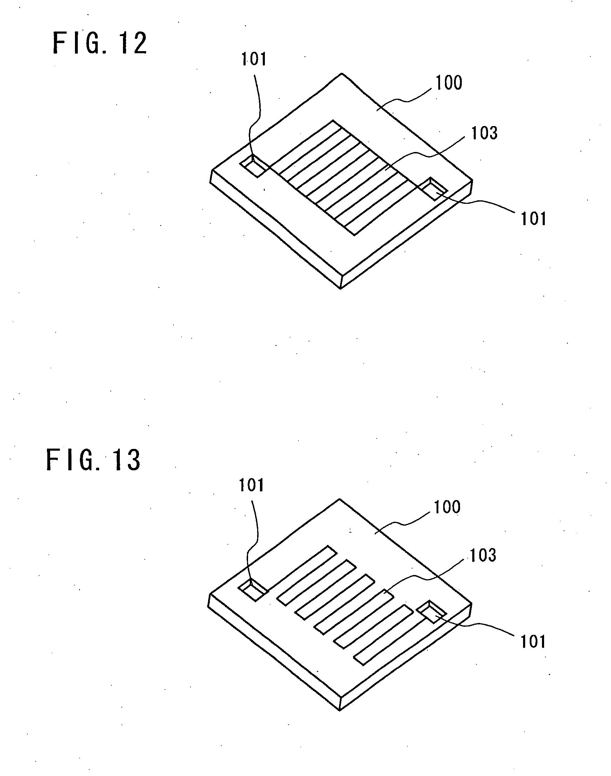

Further, by molding conductive carbon material, such as conductive resin, with the above metal structure (stamper) 58 by injection molding or press molding, it is possible to produce a channel member having a channel for supplying a fuel-cell material, shown in Figs. 12 and 13. Figs. 12 and 13 are perspective views showing the configuration of a separator 100 which is one kind of channel member. The separator 100 has two through-holes, which serve as ports 101. Material gas such as oxygen and hydrogen is supplied through one port 101 and discharged through the other port 101. The separator 100 also has a plurality of grooves in its middle part, which serve as channels 103 for connecting between the two ports 101.

The metal structure (stamper) 58 is particularly suitable for the molding of the conductive carbon material having the groove pattern with the width of 2 to 500 µm, more preferably, 2 to 100 µm, and the aspect ratio of 1 or more. If the metal structure (stamper) 58 shown in Fig. 8G is used for the production of a channel member, the pattern of the second intermediate structure 57 is transferred. Hence, a shallow groove is created from the first (lower) step of the raised portion. Thus, this part is suitable for creation of a channel of the channel member. On the other hand, a deeper groove is created from the second (higher) step of the raised portion. This, this part is suitable for creation of a port of the channel member. In this case, the first layer mask 53 is made to have the same pattern as the channel, and the second layer mask 56 the same pattern as the port. By performing the exposure using the two masks, one with the pattern corresponding to the channel and the other with the pattern corresponding to the port, it is possible to produce the metal structure (stamper) 58 used for the creation of the channel and the port.

Use of the metal structure (stamper) 58 produced as above allows accurately producing the separator for a fuel-cell. Further, it allows increasing the productivity of the separator to reduce costs for the fuel-cell. Two separators produced as above are placed face to face, and electrode and electrolyte are placed therebetween. A fuel cell is thereby created. A fuel battery is produced by lamination of the cells having the separator.

### EMBODIMENT 3

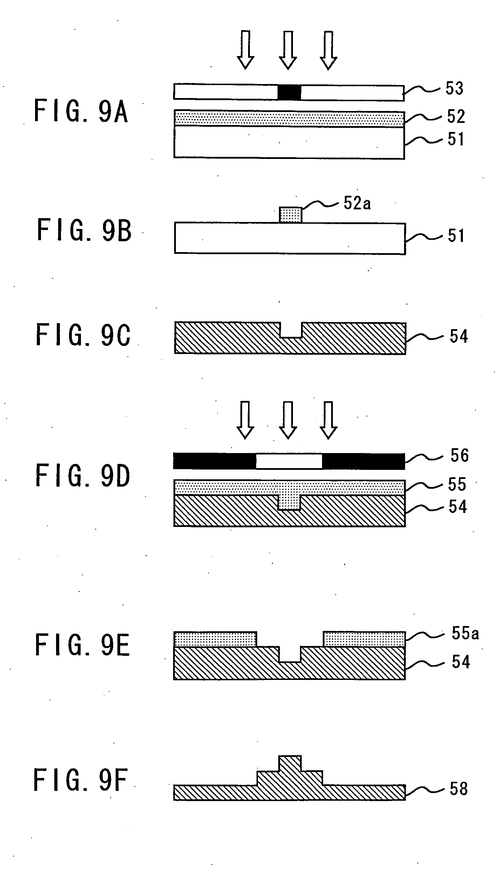

The production process of a metal structure (stamper) and a resin molded product according to another embodiment of the present invention will be explained hereinafter with reference to Fig. 9A to 9F. Fig. 9A to 9F are sectional views showing a metal structure (stamper) production process according to this embodiment. This is variant of the production process according to the second embodiment. The same reference numerals as in Fig. 8A to 8G designate the same elements, and redundant explanation will be omitted. Further, the same steps as the above embodiments are performed in the same manner as explained in the first and second embodiments, and redundant explanation will be omitted.

Firstly, the first resist layer 52 is deposited on the substrate 51. Positive resist is used for the first resist layer 52. The resist is then exposed by using the first layer mask 53 as shown in Fig. 9A. Further, the development is performed to remove the exposed area of the resist layer 52, thereby creating the first resist pattern 52a. The raised portion is thereby formed on the substrate, as shown in Fig. 9B.

Then, the steps of providing conductivity and electroforming are performed to create the first intermediate structure 54 as shown in Fig. 9C. The second resist layer 55 is then deposited over the first intermediate structure 54. This embodiment uses positive photoresist for the second resist layer 55. The resist is then exposed by using the second layer mask 56, as shown in Fig. 9D. The development is performed and the resist pattern 55a is thereby created on the first intermediate structure 54. The first intermediate structure 54 thus has a multi-step surface where a recessed portion is created on the inner bottom surface of another recessed portion, as shown in Fig. 9E. Since the patterns are created by two times of lithography processes, they are accurately formed. Then, by the conductivity producing and electroforming, the metal structure (stamper) 58 is formed, as shown in Fig. 9F. The pattern of the first intermediate structure 54 is transferred to the metal structure (stamper) 58, which thus has a multi-step surface where a raised portion is created on another raised portion. Using the metal structure (stamper) 58, the resin molded product is produced by the injection molding and so on.

The production process of the resin molded product in this embodiment forms the first intermediate structure 54, as in the second embodiment, to accurately form the metal structure (stamper) 58 having the deeper pattern than the pattern height of the first intermediate structure 54. Use of this metal structure (stamper) 58 allows producing the resin molded product with high productivity. Further, since this embodiment forms the metal structure (stamper) 58 directly from the first intermediate structure 54, it eliminates the need for forming the second intermediate structure 57, thus further increasing the productivity. The above production process can accurately produce the resin molded product with the pattern where the height of one layer is about several tens of µm and the width is about several tens of µm, or the height or the width is several µm.

Further, by molding conductive carbon material using this metal structure (stamper) 58, it is possible to produce a channel member having a channel for supplying a fuel-cell material, as described in the second embodiment. For example, a channel of the channel member can be created from the raised portion of the metal structure (stamper) 58, and a port can be created from the second (higher) step raised portion on the above raised portion. In this case, the pattern of the first layer mask 53 is the reverse pattern of the port, and exposure light is applied to the area other than the part to form the port. The pattern of the second layer mask 56, on the other hand, is the same pattern as the channel, and exposure light is applied to the part to form the channel. With the use of the masks with such patterns, only two times of the electroforming steps are required, and the metal structure (stamper) 58 for the channel member can be produced without providing the second intermediate structure. This allows increasing the productivity of the metal structure (stamper).

By molding conductive carbon material with this metal structure (stamper) 58, it is possible to accurately mold the conductive carbon material having the pattern with the width of 2 to 500 µm, more preferably, 2 to 100 µm, and the aspect ratio of 1 or more. Thus, it is possible to accurately create the channel for enhancing the electrochemical reaction and the port for supplying material to the channel.

The same effect is obtained when using negative photoresist for the second resist layer. Further, it is possible to create the pattern with two or more steps without exposing the second resist layer 55 formed inside the recessed portion of the first intermediate structure 54 in the lithography process of the second layer. It allows accurate production of the metal structure (stamper) regardless of the depth of focus.

### EMBODIMENT 4

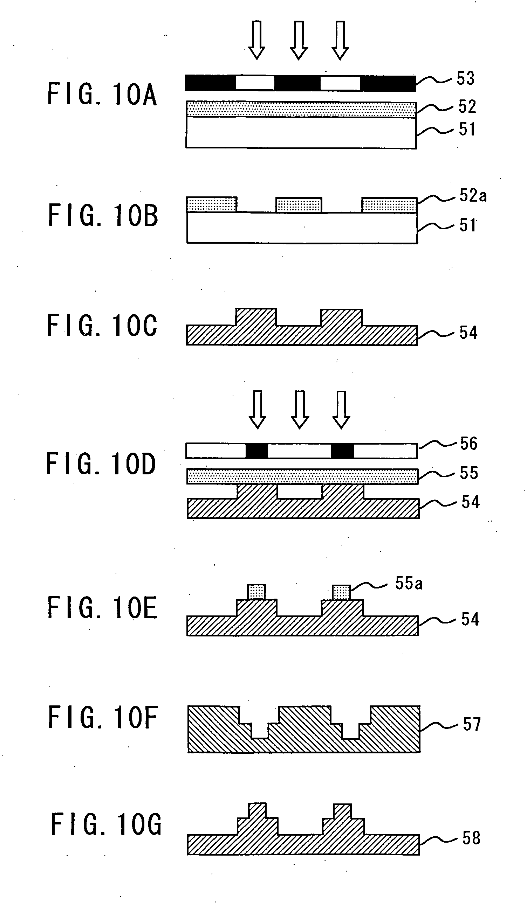

The production process of a metal structure (stamper) and a resin molded product according to another embodiment of the present invention will be explained hereinafter with reference to Fig. 10A to 10G. Fig. 10A to 10G are sectional views showing the metal structure (stamper) production process according to this embodiment. This is variant of the production process according to the second embodiment. The same reference numerals as in Figs. 8A to 9F designate the same elements, and redundant explanation will be omitted. Further, the same steps as the above embodiments are performed in the same manner as explained in the first to third embodiments, and redundant explanation will be omitted.

Firstly, the first resist layer 52 is deposited on the substrate 51. Positive resist is used for the first resist layer 52. The resist is then exposed, using the first layer mask 53, as shown in Fig. 10A. Further, the development is performed to remove the exposed area of the resist layer 52, thereby creating the first resist pattern 52a. The raised and recessed pattern is thereby formed on the substrate 51, as shown in Fig. 10B. Then, the first intermediate structure 54 is formed by conductivity providing and electroforming, as shown in Fig. 10C.

This embodiment uses dry film resist (DFR) for the second resist layer 55. The DFR is adhered to the raised portion of the first intermediate structure 54. Use of the DFR prevents a resist solution from remaining in the recessed portion of the first intermediate structure 54, allowing accurate creation of the pattern with a given pattern height. Then, the positioning of the second layer mask 56 and the exposure are performed, as shown in Fig. 10D. The development is then performed, thereby creating the second resist pattern 55a on the raised portion of the first intermediate structure 54, as shown in Fig. 10E.

After that, the conductivity providing and electroforming are performed thereon as in the second embodiment, thus forming the second intermediate structure 57 with a multi-step pattern as shown in Fig. 10F. Further, by performing the conductivity providing and electroforming, the metal structure (stamper) 58 is produced as shown in Fig. 10G. It is possible to produce the resin molded product with the metal structure (stamper) 58. This production process can accurately produce the resin molded product with the pattern where the height of one layer is about several tens of µm and the width is about several tens of µm, or the height or width is several µm. As described above, the same effect as the second embodiment may be obtained with the use of DFR; further, a resist solution does not remain in the recessed portion of the first intermediate structure 54 and more accurate pattern may be created. The DFR may be also used in the production process according in the third embodiment.

This process is particularly suitable for molding the conductive carbon material having the pattern with the width of 2 to 500 µm, more preferably, 2 to 100 µm, and the aspect ratio of 1 or more. Thus, it allows accurate creation of the channel for enhancing the electrochemical reaction and the port for supplying material to the channel. For example, a channel of the channel member may be created from the first (lower) step raised portion of the metal structure (stamper) 58, and a port may be created from the second (higher) step raised portion on the first level raised portion. In this case, the pattern of the first layer mask 53 is the same pattern as the channel, and exposure light is applied to the area other than the part to form the channel. The pattern of the second layer mask 56 is the reverse pattern of the port, and exposure light is applied to the part to form the port. With the use of the masks with such patterns, only two times of the electroforming steps are required, and the metal structure (stamper) 58 for molding the channel member for a fuel-cell may be produced without providing the second intermediate structure. This allows increasing the productivity, and mass-production enables cost reduction. The same effect may be obtained when negative photoresist is used for the second resist layer 55.

### OTHER EMBODIMENTS

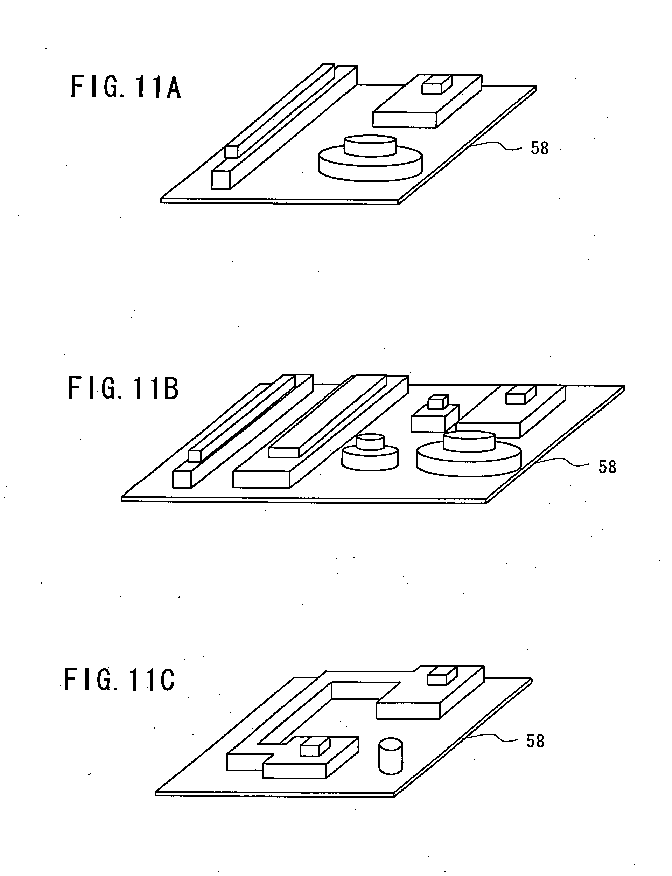

The above embodiments allows production of the metal structure (stamper) where a line-and-space pattern, a cylindrical pattern including an elliptic pattern, and a polygonal pattern such as a quadratic pattern are accurately created, with high productivity. For example, it is possible to produce multi-step pattern metal structures (stampers) for a resin molded product and for a channel member, as shown in Figs. 11A, 11B, and 11C. The metal structures (stamper) in Figs. 11A, 11B, and 11C are shown by way of example only, and their configurations are not limited thereto. Further, the present invention is not limited to the metal structure ( stamper) with the two-step or three-step surface, and it is also applicable to the metal structure (stampers) with the four- or more step surface. In this case, the channel member may have the channels with different heights.

It is also possible to use the above embodiments in combination. The production process explained in the second embodiment may be applied to any embodiments. Further, the metal structure (stamper) for resin molded product in this invention may be used for producing a micro device such as a micro reactor and a printed circuit board. Besides, except when indicated in the above embodiments, the negative resist may be replacedwith the positive resist, and the positive resist may be replaced with the negative resist. Particularly, the second- or higher level resist layers may be formed by positive or negative resist.

The channel member according to the present invention is not necessarily applied to DMFC fuel cells, and it may be also applied to Polymer Electrolyte Fuel Cell (PEFC) fuel cells, for example. Further, the metal structure (stamper) obtainable by the process according to this invention may be also used for molding a reactor for a fuel cell.

The present invention can produce a resin molded product with a given pattern, and a resin molded product having an accurate multi-step pattern with high productivity.

From the invention thus described, it will be obvious that the embodiments of the invention may be varied in many ways. Such variations are not to be regarded as a departure from the spirit and scope of the invention, and all such modifications as would be obvious to one skilled in the art are intended for inclusion within the scope of the following claims.

## Claims

1. A process of producing a resin molded product, comprising:
a step of forming a resist pattern on a substrate;
a step of forming a metal structure by depositing a metal in accordance with the resist pattern on the substrate; and
a step of forming a resin molded product by using the metal structure,
wherein the step of forming a resist pattern comprises:
a step of forming a plurality of resist layers on the substrate; and
a step of developing the plurality of resist layers through solubility control in such a way that an upper resist layer has lower solubility in a developer than a lower resist layer.

2. A process of producing a resin molded product according to Claim 1,
wherein the solubility control comprises heat treatment control performed before the development step, for controlling amount of heat-treatment of the lower resist layer and the upper resist layer.

3. A process of producing a resin molded product according to Claim 2, wherein the step of forming a resist pattern comprises:
a step of performing heat-treatment of the lower resist layer before exposure of the lower resist layer; and
a step of performing heat-treatment of the upper resist layer before exposure of the upper resist layer.

4. A process of producing a resin molded product according to Claim 2, wherein the step of forming the resist pattern comprises:
a step of performing heat-treatment of the lower resist layer after exposure of the lower resist layer; and
a step of performing heat-treatment of the upper resist layer after exposure of the upper resist layer.

5. A process of producing a resin molded product according to one of Claims 1 to 4,
wherein the step of forming a resist pattern comprises, before the development step:
a step of exposing the lower resist layer; and
a step of exposing the upper resist layer, and
the solubility control comprises exposure control for controlling amount of exposure of the lower resist layer and the upper resist layer.

6. A process of producing a resin molded product according to Claim 1, wherein the lower resist layer and the upper resist layer are made of resist of which solubility in a developer changes by exposure and heat treatment, and
the step of forming a resist pattern comprises, before the development step,
a step of exposing the lower resist layer;
a step of depositing the upper resist layer without performing heat treatment of the exposed lower resist layer; and
a step of performing heat treatment of the upper resist layer after exposing the upper resist layer.

7. A process of producing a resin molded product having an uneven surface useful for material processing, comprising:
a step of forming a resist pattern on a substrate;
a step of forming a metal structure by depositing a metal in accordance with the resist pattern on the substrate; and
a step of forming a resin molded product by using the metal structure,
wherein the step of forming a resist pattern comprises:
a step of forming a plurality of resist layers; and
a step of developing a lower resist layer exposed with a mask pattern and an upper resist layer exposed with a mask pattern of the plurality of the resist layers, to form a resist pattern having a raised or recessed portion with a plurality of different heights.

8. A process of producing a resin molded product according to one of Claims 1 to 7, wherein the step of forming a resist pattern comprises:
a step of depositing a plurality of resist layers; and
a step of exposing the plurality of resist layers at a time with an exposure mask or exposing each of the plurality of resist layers with an exposure mask of the same pattern, to form a pattern with a predetermined height.

9. A process of producing a resin molded product according to one of Claims 1 to 8, wherein the step of forming a resist pattern further comprises a step of depositing and exposing one or more resist layers after exposing the upper resist layer, to create a raised or recessed portion with two or more different heights.

10. A process of producing a resin molded product according to one of Claims 7 to 9, wherein in the step of forming a resist pattern a resist pattern having a raised or recessed portion with a plurality of different heights is formed in one development step.

11. A process of producing a resin molded product having a groove with a width of 2 to 500 µm and an aspect ratio of 1 or more, and a through-hole, comprising:
a step of forming a metal structure; and
a step of forming a resin molded product,
wherein the step of forming a metal structure comprises:
a step of forming a first structure having an uneven surface;
a step of forming a resist layer on the uneven surface of the first structure;
a step of forming a resist pattern by forming a raised or recessed portion of the resist pattern on a raised portion of the uneven surface of the first structure, or by forming a recessed or raised portion of the resist pattern on a recessed portion of the uneven surface of the first structure; and
a step of forming a second structure by depositing material for forming the second structure on the uneven surface of the first structure where the resist pattern is formed.

12. A process according to one of Claims 1 to 11, wherein a light source used for exposure in the step of forming a resist pattern is an ultraviolet lamp or a laser.

13. A process of producing a resin molded product according to one of Claims 1 to 12, wherein a height of a raised or recessed portion of a resin molded product formed by the step of forming a resin molded product is substantially 5 µm to 500 µm.

14. A resin molded product obtainable by a process according to one of Claims 1 to 13, comprising at least one selected from a channel pattern, a mixing part pattern, a reservoir pattern, an electrode, a heater, and a temperature sensor.

15. A chip for clinical laboratory testing, obtainable by a process according to one of Claims 1 to 12.

16. A chip for combinatorial chemistry, obtainable by a process according to one of Claims 1 to 12.

17. A chip for genetic applications, obtainable by a process according to one of Claims 1 to 12.

18. A channel member for a fuel cell, obtainable by a process according to one of Claims 1 to 12.

19. A process of producing a metal structure for forming a resin molded product, comprising:
a step of forming a resist pattern on a substrate; and
a step of forming a metal structure used for forming a resin molded product by depositing a metal in accordance with the resist pattern on the substrate;
wherein the step of forming a resist pattern comprises :
a step of forming a plurality of resist layers; and
a step of developing the plurality of resist layers on the substrate through solubility control in such a way that an upper resist layer has lower solubility in a developer than a lower resist layer.

20. A process of producing a metal structure for forming a resin molded product, having an uneven surface useful for material processing, comprising:
a step of forming a resist pattern on a substrate; and
a step of forming a metal structure by depositing a metal in accordance with the resist pattern on the substrate;
wherein the step of forming a resist pattern comprises :
a step of forming a plurality of resist layers; and
a step of developing a lower resist layer exposed with a mask pattern and an upper resist layer exposed with a mask pattern of the plurality of the resist layers, to form a resist pattern having a raised or recessed portion with a plurality of different heights.

21. A process of producing a metal structure for forming a resin molded product, having a groove with a width of 2 µm to 500 µm and an aspect ratio of 1 or more, and a through-hole connected to the groove, comprising:
a step of forming a first structure having an uneven surface;
a step of forming a resist layer on the uneven surface of the first structure;
a step of forming a resist pattern by forming a raised portion of the resist pattern on a raised portion of the uneven surface of the first structure, or by forming a recessed portion of the resist pattern on a recessed portion of the uneven surface of the first structure; and
a step of forming a second structure by depositing material for the second structure on the uneven surface of the first structure where the resist pattern is formed.
